(19) **Europäisches Patentamt European Patent Office Office européen des brevets**

(11) **EP 4 538 673 B1**

(12) **EUROPEAN PATENT SPECIFICATION**

(45) Date of publication and mention
of the grant of the patent:
**03.12.2025 Bulletin 2025/49**

(51) International Patent Classification (IPC):
**G01N 1/28** *(2006.01)* **G01N 1/36** *(2006.01)*
**G01N 1/42** *(2006.01)* **H01J 37/20** *(2006.01)*

(21) Application number: **23203613.7**

(22) Date of filing: **13.10.2023**

(52) Cooperative Patent Classification (CPC):
**G01N 1/2813; G01N 1/36; G01N 1/42;**
H01J 2237/2001; H01J 2237/2004

(54) **A METHOD FOR INVESTIGATING A NANOSCALE BIOLOGICAL SPECIMEN IN AN ELECTRON BEAM INSTRUMENT, WITH REDUCED RADIATION DAMAGE**

VERFAHREN ZUR UNTERSUCHUNG EINER BIOLOGISCHEN PROBE IM NANOMASSSTAB IN EINEM ELEKTRONENSTRAHLINSTRUMENT MIT REDUZIERTER STRAHLUNGSSCHÄDIGUNG

PROCÉDÉ D'ÉTUDE D'UN SPÉCIMEN BIOLOGIQUE NANOMÉTRIQUE DANS UN INSTRUMENT À FAISCEAU D'ÉLECTRONS, AVEC RÉDUCTION DES DOMMAGES CAUSÉS PAR UN RAYONNEMENT

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**16.04.2025 Bulletin 2025/16**

(73) Proprietor: **Bruker AXS SE**
**76187 Karlsruhe (DE)**

(72) Inventors:
 • **De Jonge, Niels**
  **76187 Karlsruhe (DE)**
 • **Keskin, Sercan**
  **76187 Karlsruhe (DE)**
 • **Kramer, Matthias**
  **76275 Ettlingen (DE)**

(74) Representative: **Kohler Schmid Möbus**
**Patentanwälte**
**Partnerschaftsgesellschaft mbB**
**Gropiusplatz 10**
**70563 Stuttgart (DE)**

(56) References cited:
**WO-A1-2015/134575 US-A1- 2023 282 470**

 • **R. BRYDSON ET AL: "Microscopy of nanoparticulate dispersions : MICROSCOPY OF NANOPARTICULATE DISPERSIONS", JOURNAL OF MICROSCOPY, vol. 260, no. 3, 6 August 2015 (2015-08-06), GB, pages 238 - 247, XP055723506, ISSN: 0022-2720, DOI: 10.1111/jmi.12290**
 • **ILETT MARTHA ET AL: "Cryo-analytical STEM of frozen, aqueous dispersions of nanoparticles", MICRON, vol. 120, 31 January 2019 (2019-01-31), GB, pages 35 - 42, XP093143113, ISSN: 0968-4328, DOI: 10.1016/j.micron.2019.01.013**
 • **NICOLE HONDOW ET AL: "Quantitative characterization of nanoparticle agglomeration within biological media", JOURNAL OF NANOPARTICLE RESEARCH ; AN INTERDISCIPLINARY FORUM FOR NANOSCALE SCIENCE AND TECHNOLOGY, KLUWER ACADEMIC PUBLISHERS, DO, vol. 14, no. 7, 23 June 2012 (2012-06-23), pages 1 - 15, XP035089870, ISSN: 1572-896X, DOI: 10.1007/S11051-012-0977-3**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The invention relates to a method for investigating nanoscale biological specimens in an electron beam instrument.

Such a method is for example known from US 7,413,872.

Electron beams are frequently used to examine the structure of nanoscale biological objects such as proteins or virus particles via direct microscopy or via diffraction methods. A typical instrument to investigate nanoscale biological objects is a transmission electron microscope (=TEM); note that nanoscale biological objects subject to an investigation are also called nanoscale biological specimens.

To achieve a spatial resolution in the sub-nanometer range, significant doses of electrons of an electron beam are required. There are specimens that can stand even high doses of electrons, such as metallic nanoparticles. However, a broad range of specimens is rapidly damaged in the electron beam, such as polymers, certain battery materials involving lithium, and most biological specimens such as proteins and virus particles. Typically, the electron dose limit for proteins and virus particles is 10 electrons per $\text{Å}^2$, for which sufficient signal-to-noise-ratio (=SNR) is obtained for a spatial resolution of approximately 5 nm under standard conditions. A better resolution would require a higher electron dose, whereby the dose scales with at least the square of the spatial resolution (see textbook: L. Reimer, H. Kohl, Transmission Electron Microscopy: Physics of Image Formation, Springer, 2008, page 479, equation 11.17), but a stronger scaling up to the fourth power under certain conditions has also been reported (N. de Jonge, Ultramicroscopy 187 (2019) 113-125). To resolve the structure of a wide range of biological nanoscale objects, a spatial resolution of at least 0.5 nm would be needed, and it is thus highly desired to mitigate radiation damage.

The key problem in electron microscopy of biological samples is the occurrence of radiation damage via inelastic electron scattering (R. F. Egerton, Micron 119 (2019) 72-87). Damaging processes include the creation of excited states in molecules, and the creation of charge pairs (ionization). If charge pairs are created at the surface of the sample, emission of secondary electrons may take place resulting in electrical charging of the sample. Structural damage to the sample mainly occurs when atomic bonds are broken following inelastic scattering processes. Heating up of the sample is not relevant for typical conditions involving biological samples. Another process, so-called knock-on damage, is typically of much smaller magnitude than damage via charging effects, and it can be overcome by lowering the beam energy below the knock-on threshold, although the energy level to prevent damage on hydrogen is so low that a limited spatial resolution can be achieved.

A *first partial remedy* to radiation damage is to lower the influx of electrons (also simply called electron flux) such that the number of created excited states and charge pairs per unit time is reduced (E. E. Fill, F. Krausz and M. G. Raizen, New J. Phys. 10 (2008) 93015-1-7). At the typical experimental conditions in electron microscopy, multiple adjacent charge pairs are created such that the net Coulomb force is in outward direction, promoting beam damage. Below a threshold influx, only one adjacent charge pair is present at one time point, such that the net Coulomb force is towards recombination. Mitigation of beam damage by operating the electron beam at a low electron flux has been reported in the open literature, for example, S. Keskin and N. de Jonge, Nano Lett. 18 (2018) 7435-7440. Examination of a biological specimen with transmission electron microscopy was conducted with a low flux of the electron beam, below 5 $e^-\text{Å}^{-2}\text{s}^{-1}$, such that electron beam damage by electrical charging was reduced, while radiation damage occurred at higher flux for the same sample.

For charge separation to be equilibrated in organic molecules, an electron transfer process needs to take place. The rate constant in electron transfer between two fixed redox states is given by (R. A. Marcus, N. Sutin, Biochim. Biophys. Acta 811 (1985) 265-322):

$$k = \sqrt{\frac{4\pi^3}{h^2\lambda k_b\,T}}\,H_{ab}^2\,e^{-\frac{(\Delta G^0 + \lambda)^2}{4\lambda k_b T}}, \qquad\qquad \text{eq. 1}$$

with driving force $-\Delta G^0$, temperature T, Boltzmann's constant $k_b$, reorganization energy $\lambda$, and electronic coupling $H_{ab}$. In one model, $H_{ab}$ is given by (C. C. Moser et al., Nature 355 (1992) 796-802):

$$H_{ab}^2 = V_0^2\,e^{-\beta R}, \qquad\qquad \text{eq. 2}$$

with distance between donor and acceptor R, tunneling factor $\beta$, and maximal electronic coupling $V_0$. Depending on how far an electron created in an ionization event travelled, the recombination time thus varies, but the time also depends on the exact electron transfer pathways in the molecule (D. N. Beratan et al., Science 252 (1991) 1285-1288). Electron transfer in a protein typically occurs around room temperature, and at distances less than a few nanometers.

Important is furthermore that the object is placed on an electrically conductive support, which is connected to the electrical neutral (in general "earth" potential) of the electron beam instrument. The latter is typically achieved by placing the sample on an electrically conductive foil, for example, a carbon foil that is placed in the instrument by means of a specimen holder.

A *second partial remedy* against radiation damage is by freezing the sample of specimens that are normally in a liquid state, such as most biological specimens. Primary damage occurs when an electron directly hits the object under observation, while secondary damage occurs after the medium surrounding the object has been hit, and chemical radicals and free electrons diffuse towards the object, creating damage. In addition, molecular structures in which bonds are broken, remain fixed in a solid ice matrix thus reducing structural degradation. Freezing the medium protects the sample against secondary radiation damage because of the reduced diffusion and the increased structural stability compared to the situation in liquid (L. F. Kourkoutis et al., Annu. Rev. Mater. Res. 42 (2012) 33-58).

A practical problem is that freezing a biological may lead to ice crystals damaging the morphology of the investigated sample. The state-of-the-art method used in structural biology is to freeze a sample sufficiently fast and down to liquid nitrogen temperatures such as to obtain amorphous ice. The sample typically consists of a saline layer containing protein placed on a carbon film with holes. After removing excess liquid and rapid freezing, the resulting free standing amorphous ice layer in the holes in the carbon film has a thickness of about 50 - 70 nm. During the examination of proteins in this free standing ice layer, the temperature is kept below the so-called glass transition temperature of ice (typically about 100° K). Ice crystal formation is thus prevented.

However, ice at the above-mentioned low temperature is an insulator. Pure ice exhibits a poor static electrical conductivity of $\sigma = 10^{-7} \ \Omega^{-1}m^{-1}$ at freezing point (see G. W. Gross et al., J. Glaciol. 21 (1978) 143) and decreases to values below $10^{-12} \ \Omega^{-1}m^{-1}$ for temperatures below 200 K. Ice at the later temperature remains an insulator even when ions are mixed with the ice (see Stillman and Grimm, Lunar and Planetary Science XXXIX (2008) 2277). Charge compensation from the electrical neutral of the instrument to the sample upon the emission of secondary electrons is thus impossible. Above a certain electron dose, the sample charges up so much that the electric field in the sample exceeds the dielectric strength of ice of $8 \times 10^7 \ Vm^{-1}$ (T. Kohno et al., IEEE Transactions on Electrical Insulation, EI-15 (1980) 27-32), and sample damage occurs, for example, the formation of hydrogen gas.

Also, charge transfer rates within the object become highly limited. To exemplify the influence of the above-mentioned temperature on electron transfer, one may consider eq. 1 for typical values of $\Delta G^0 = -1.5$ eV, and $\lambda = 0.75$ eV in a protein, and a temperature change from 293 K to 77 K. This temperature change would result in a reduction of the electron transfer rate by a factor of $6 \times 10^8$, which would basically block electron transfer in the protein. Yet, electron transfer is possible within the protein if $-\Delta G^0 = \lambda$ (H. Wang et al., J. Phys. Chem. B 113 (2009) 818-824), which is only rarely the case in practice. Therefore, at low temperature, radiation damage mitigation is impossible via operating at a low electron flux such that charge pairs can recombine. Cryogenic sample damage thus occurs above a certain threshold electron dose, typically 10 e-Å$^{-2}$.

Consequently, the above mentioned first partial remedy against radiation damage cannot be combined with the above mentioned second partial remedy against radiation damage, limiting the effect of the available radiation damage mitigation strategies.

The current method to overcome the radiation damage limit of frozen biological specimens is via so-called single-particle tomography ("Single-particle reconstruction of biological molecules - story in a sample", Nobel Lecture, December 8, 2017 by Joachim Frank). In this method, images of many similar objects, for example, a single type of purified protein or virus particle, are recorded via transmission electron microscopy (TEM). The objects are embedded in a thin layer of ice and are deposited at random orientations. The electron dose is limited to a value below the damage threshold of 10 electrons per Å$^2$, and as a result, each image exhibits a poor signal-to-noise-ratio (SNR). A three-dimensional structure is then computed by averaging many tens of thousands of images, such to increase the SNR. But in this case, information of the unique structure of single objects, for example, a protein is not available, and information about differences between structural subclasses is not available when the number of objects in a class is smaller than the number of images of objects that needs to be averaged to achieve the required SNR, which severely limits the study of protein function.

In US 7,659,510 it is proposed to dope ice cooled at the temperature of liquid nitrogen, for example, with ions, for example Na$^+$Cl$^-$, with the purpose of making the ice conductive at liquid nitrogen temperature. The doping changes the bandgap of the insulating ice, and then an electrical potential is placed over the sample such as to charge the sample. Similar approaches are described in US 2012/0220046 A, US 2010/0243482 A and Chih-Yu Chao, Chinese Journal of Physics Vol. 45, No. 6-I, December 2007, 557-578.

However, typically, ion mobility approaches zero in ice at liquid nitrogen temperature. Moreover, amorphous ice does not contain crystalline domains as known in a typical semiconductor, for example, a silicon crystal. Therefore, there is no continuous conductive path as needed for the sample to become electrically conductive.

US 7,413,872 describes a device for preparing specimens for a cryo-electron microscope. In an environmental chamber, there is arranged a holder for a sample or a carrier, and at least one blotting element to which a medium for absorbing liquid is attached. A grid is immersed in a suspension of particles to be examined. As a result of blotting, a film thickness in the openings of the grid is reduced for example from 3-4 $\mu$m to 100 nm. The sample is cooled down very quickly so that the fluid becomes vitreous. The specimen is examined by cryo-microscopy for example at -170°C.

Further, US 7,420,184 describes a sample holder for electron microscopy with a temperature switch, so that a sample can switched between a temperature of liquid nitrogen and room temperature.

US 2023/0282470 A1 describes the preparation of cryo electron microscopy samples. A beam containing a solvent and an analyte is directed to a receiving surface of a substrate which is cooled to a temperature of 0°C or less. On the receiving surface, there is formed an amorphous solid layer with a thickness of 100 nm or less. An electron microscopy grid comprising a graphene film or membrane may be used.

WO 2015/134575 A1 describes a thin-ice grid assembly for cryo-electron microscopy. A biological sample in aqueous solution is placed between support members separated by a spacer having a thickness between 10 nm and 300 nm. The sample is fast frozen, in particular by plunging the grid assembly into liquid nitrogen. Martha Ilett et al, "Cryo-analytical STEM of frozen, aqueous dispersions of nanoparticles", Micron 120 (2019), 35-42 report the preparation of cryo TEM samples. Particle suspensions of deionized water and metal oxide or metal nanoparticles were placed on a carbon coated TEM grid, blotted and plunged into liquid ethane. A cryo holder maintaining the temperature below -165°C was used for TEM. An ice thickness was found to vary across the grid, and analysis was conducted in areas where thickness was below 200 nm.

Nicole Hondow et al, "Quantitative characterization of nanoparticle agglomeration within biological media", Journal of Nanoparticle Research, vol. 14, no. 7 (2012), 1-15 report that a droplet of each of several nanoparticle dispersions was placed on a glow discharge-treated carbon support film, blotted, and plunge frozen in liquid ethane. Samples that were to be examined by cryo-TEM were subsequently transferred cold to a cryo-holder cooled by liquid nitrogen, or stored in liquid nitrogen. Some samples were just examined by TEM at room temperature and these were plunge frozen, stored at liquid nitrogen temperatures, and warmed to room temperature over several minutes by placing the specimen in its liquid nitrogen cooled storage container in a rotary pumped vacuum desiccator.

Object of the invention

It is the object of the present invention to provide a method for investigating nanoscale biological specimens, wherein a single nanoscale biological specimen can be investigated at a high spatial resolution in a simple manner.

Short description of the invention

This object is achieved, in accordance with the invention, by a method for investigating at least one nanoscale biological specimen, the method comprising

Step a) preparing an embedding liquid containing a plurality of the nanoscale biological specimens, wherein the nanoscale biological specimens have a maximum diameter MD, with MD $\leq$ 30 nm,

Step b) preparing a thin film of the embedding liquid on an electrically conductive substrate in an application zone, thereby placing the nanoscale biological specimens on the substrate,

wherein the substrate is wettable for the embedding liquid in the application zone, and wherein the thin film of the embedding liquid has an average thickness AT, with AT $\leq$ 30 nm;

wherein step a) and step b) are done at a preparation temperature PT, with PT > 0°C;

Step c) tempering the thin film on the substrate to a measurement temperature MT, with -100°C$\leq$MT$\leq$1°C;

Step d) measuring at least one of the nanoscale biological specimens within the thin film on the substrate in an electron beam instrument at the measurement temperature MT,

wherein the at least one nanoscale biological specimen is exposed to an electron beam.

The inventive method suggests preparing the nanoscale biological specimens to be investigated in a thin film on a substrate in accordance with step b), with the thin film having a small average thickness AT, with AT $\leq$ 30 nm. The nanoscale biological specimens have a maximum diameter MD, with MD $\leq$ 30 nm.

According to the invention, step a) and step b) are done at a preparation temperature PT, with PT > 0°C. This simplifies performing steps a) and b).

The small film thickness of the thin film has the advantage that the thin film can be tempered (in general cooled) in step c) to a moderately low temperature, chosen between -1°C and -100°C, preferably between -1° and -50°C, without the formation of ice crystals which might damage the nanoscale biological specimen.

The thin film tempered to said temperature is subjected to measurement in an electron beam instrument, typically a TEM (transmission electron microscope), in step d); this is why said temperature is also called the measurement temperature MT.

By tempering the thin film in step c) to the moderately low measurement temperature MT, the thin film or its embedding liquid becomes immobilized or stabilized (or at least less mobile and more stable, as compared to the situation at a preparation temperature of step b), which is typically at room temperature). In general, the thin film applied from the embedding liquid is not in liquid state at the measurement temperature MT. First, the thin film can longer resist a vacuum present during step d) in the electron beam instrument; the thin film will exhibit a low and often negligible evaporation (over the measurement time) in the vacuum. Second, diffusion of chemical radicals and free electrons is reduced, which reduces radiation damage (due to "secondary damage") during the measurement of at least one nanoscale biological specimen under the electron beam irradiation. Third, structural stability is provided to the sample.

Equally important with respect to radiation damage, the measurement temperature MT between -100°C and -1°C, and preferably between -50°C and -1°C, is still relatively high, as compared to state-of-the-art investigation at about liquid nitrogen temperature (-196°C = 77K). This relatively high measurement temperature improves electron transfer within a respective biological specimen, and improves electron transfer between a respective biological specimen and the (electrically conductive) substrate and its sample support. Also, the improved electron transfer, and in particular the improved electric conductivity within the immobilized embedding liquid, improves recombination of charge pairs, and accumulation of charges only occurs at relatively high electron fluxes then.

Therefore, with the sample preparation and measurement of the inventive method, both higher electron doses (in particular 10 electrons per $Å^2$ or more, and often of 50 electrons per $Å^2$ or more) and higher electron fluxes (often at 5 electrons per $Å^2$ and per s or more) can be tolerated during measurement of the at least one nanoscale biological specimen, without suffering significant radiation damage. Accordingly, a relatively high spatial resolution in an electron beam measurement (in particular TEM measurement) may be achieved, within a relatively short measurement time or with a relatively small number of objects that need to be averaged to obtain sufficient SNR.

However, note that the electron flux should still be low enough in order to allow charge recombination without charge accumulation. Typically a flux of electrons at or below 50 electrons per $Å^2$ per s and preferentially around 10 electrons per $Å^2$ per s for a typical electron beam energy between 30 and 300 keV used in high-resolution transmission electron microscopy is adequate in the inventive method; note here that lower electron energies may also be used in the range of 50 eV- 30 keV as used in other electron beam instruments.

The nanoscale biological specimen to be investigated is typically a protein, but may also be a peptide, a virus particle, a DNA sequence or something else that can be found in a human or animal body or a plant or a fungus.

In order to facilitate preparing the thin film, the substrate is wettable for the embedding liquid at least in the application zone (in particular with a contact angle alpha < 90°, preferably < 45°). In this way, the embedding liquid spreads itself over the application zone. In order to achieve the low thickness, liquid may be deliberately removed, for example by blotting or evaporation, and/or only a few femtoliters of embedding liquid are initially placed on the substrate (see also below).

Note that measuring at least one nanoscale biological specimen with the electron beam in step d) is typically done in order to examine the structure of the nanoscale biological specimen. The measurement may in particular include phase contrast (including bright field imaging and dark field imaging), diffraction, holography or ptychography, typically in a transmission electron microscope.

Preferred variants of the invention

A preferred variant of the inventive method is characterized in that the measurement temperature MT is less than a freezing temperature of the embedding liquid in bulk. The thin film of embedding liquid is reliably immobilized or stabilized by choosing a measurement temperature below the freezing point *of the embedding liquid in bulk.* Note that due to the low film thickness, the thin film can be prevented from forming ice crystals, even below the freezing point of the embedding liquid in bulk. The measurement temperature may be kept above a freezing temperature *of the thin film* of the embedding liquid (as applicable), the latter temperature may be lower than the freezing temperature of the embedding liquid in bulk due to boundary layer effects. Note that the thin film of embedding liquid may, in particular, assume a gel-like state or an amorphous state or a cured state or some different state at the measurement temperature. The freezing temperature of the embedding liquid in bulk may easily be determined by experiment, for example, with a macroscopic sample of the embedding liquid in a test tube and slowly lowering the test tube temperature; the freezing of the embedding liquid is well visible with the naked eye or can be detected with a sensor easily. If desired, the film may also be cooled below a freezing temperature *of the thin film* of the embedding liquid, and here, AT should be smaller than MD to avoid ice crystal formation. Whether ice crystals are formed can easily be checked via a transmission electron microscopy image, and AT decreased as needed.

That ice crystal formation can be prevented for a very thin layer of liquid follows from the ice nucleation rate. For example, for pure water, the nucleation rate for ice nucleation is $10^{14}$ $m^{-3}s^{-1}$, but the latter value drops eight orders of magnitude down to $10^6$ $m^{-3}s^{-1}$ for a nanodroplet of 2.4 nm in radius, thus obtaining a nanoscale droplet of supercooled water. Ice nucleation is altogether avoided for nanodroplets placed on a flat surface. Thus, ice crystals would not form in a water layer of a thickness of about 3 nm at a surface of a graphene film as sample support. In practice, the liquid layer can be somewhat thicker (for example, 5 nm) when using not pure water but saline, for example, water mixed with, for example, NaCl, which reduces the nucleation for crystallization compared to ice, so that a thicker layer still does not crystallize.

By tempering the thin film of embedding liquid and the nanoscale biological specimens in the embedding liquid on the substrate (or simply tempering the sample) to the measurement temperature below the freezing temperature of the embedding liquid in bulk, diffusion of chemical radicals and free electrons is reduced, and the thin film of embedding liquid is prevented from evaporating in the vacuum of the electron microscope.

In a preferred variant, there is chosen AT≤MD. This helps to avoid the formation of ice crystals in the embedding liquid of the thin film when tempering the thin film to the measurement temperature.

A further preferred variant provides that in step d), an electron beam energy of the electron beam is between 50 eV and 300 keV,

preferably between 30 keV and 300 keV,
and the electron flux of the electron beam is between 0.1 electrons per Å$^2$ per s and 50 electrons per Å$^2$ per s, preferably between 1 electron per Å$^2$ per s and 10 electrons per Å$^2$ per s. These parameters have been proven in practice. In particular, with the above electron flux, radiation damage reduction by charge recombination can be supported for the typical conditions in a high-resolution TEM apparatus.

In a preferred variant, the preparation temperature is in a range of 0°C<PT≤40°C, and often with PT at room temperature (20°C).

Highly preferred is a variant including during step b), placing an initial large amount of embedding liquid on the substrate, with the large amount being larger than needed for the thin film, and then reducing the amount of embedding liquid on the substrate until only the thin film remains. This process is particularly simple to put into practice, and application zones can be loaded with embedding liquid fast and reliably. Further, if desired, it is easy to load plenty of application zones (in particular 5 or more, or even 20 or more) at a time with embedding liquid.

Preferred is a further development of this variant characterized in that reducing the amount of embedding liquid includes placing a liquid absorbing medium in contact with the embedding liquid,

in particular wherein the liquid absorbing medium comprises a filter paper or a brushed metallic wire, and/or in that reducing the amount of embedding liquid includes evaporating some of the embedding liquid. Reducing the amount of the embedding liquid by contacting with a liquid absorbing medium is also called blotting. By blotting, particularly large amounts of embedding liquid can be removed in a fast way. In particular, a TEM grid carrying the substrate (with the substrate such as a graphene foil or carbon foil having breakthroughs such as fine fissures) may be pressed onto a filter paper. For evaporating some of the embedding liquid, typically simply some time is waited, preferably a defined time in a defined atmosphere. Typically, the evaporation is done at room temperature and/or regular atmosphere; alternatively, it may be performed at set conditions, in particular at an elevated temperature as compared to room temperature, or at a reduced humidity in the atmosphere surrounding the substrate, in particular after having applied the embedding liquid on the substrate. By evaporation the thickness of the thin film may be set very accurately, and further the achievable density of nanoscale biological specimens in the thin film is particularly high.

Advantageous is further a variant wherein during step b), for preparing the thin film of embedding liquid in the application zone having an application zone area AZA, an initial small volume SV of embedding liquid is placed on the substrate in the application zone, with SV ≤ AT*AZA. When the initial small volume of the embedding liquid, after having been applied to the application zone, spreads over the application zone of the substrate (which is wettable for the embedding liquid there), the desired average thickness of the thin film can be achieved "by itself" in this case. Note that in this variant, reducing the amount of applied embedding liquid in step b) is generally not necessary; however sometimes in this variant some evaporation of embedding liquid is performed, too.

Further preferred is a variant wherein in step b) an initial amount of embedding liquid is placed on the substrate in the application zone by first dipping an application tip, in particular an atomic force microscopy (=AFM) tip, into a supply pool of the embedding liquid containing the nanoscale biological specimens, and then touching the application zone with the application tip. Touching the application zone with the tip includes, in the sense of the present invention, both that the application tip immediately touches the application zone, or a drop of embedding liquid adhering to the tip touches the application zone. This is a practical procedure to place a small amount of embedding liquid on the substrate or an application zone of it, in particular a small volume SV of embedding liquid as mentioned above. The material of the application tip should be wettable for the embedding liquid (with a contact angle beta < 90°, preferably beta < 45°), but preferably not as good as the substrate in the application zone (that is preferably alpha < beta, with alpha being the contact angle of the embedding liquid on the substrate in the application zone, and beta being the contact angle of the embedding liquid on the tip material). The amount of liquid stuck to the application tip can be adjusted via the dipping depth of the application tip into the surface of the embedding liquid in the supply pool.

Also preferred is a variant wherein in step b) an initial amount of embedding liquid is placed on the substrate in the application zone with an application tip having a microchannel through which the initial amount of the embedding liquid is discharged. This is also a practical way to place a small amount of embedding liquid on the substrate or its application zone, in particular a small volume SV as mentioned above.

Further preferred is a variant wherein during step b), an initial volume of embedding liquid placed on the substrate is between 1 fL and 2 μL. Note that a typical initial volume of embedding liquid is 0.2 μL - 2 μL in case of subsequently reducing the amount of embedding liquid, for example, by blotting or evaporation. Typical amounts of embedding liquid corresponding to a small volume SV as mentioned above, according to the invention, are in general on the order of 1 fL to 100 fL (for example, for a typical 3 mm TEM grid with a mesh of 200, corresponding to a typical TEM grid window of length 60 μm, has AZA= 3600 μm$^2$, and AT= 10 nm, then results SV= 36 fL (3.6*10-17 m$^3$).

In an advantageous variant, experimental parameters applied during step b) in order to prepare the thin film with the average thickness AT have been determined in advance in calibration experiments,

in particular wherein the experimental parameters include at least one of: temperature of an atmosphere surrounding the substrate, pressure of an atmosphere surrounding the substrate, humidity of an atmosphere surrounding the substrate, composition of an atmosphere surrounding the substrate, temperature of the substrate, type of a liquid absorbing medium, contact time with a liquid absorbing medium, contact pressure to a liquid absorbing medium, evaporation time, initial large amount of embedding liquid placed on the substrate, initial small volume SV of embedding liquid placed on the substrate in an application zone, initial amount of embedding liquid placed on the substrate, initial volume of embedding liquid placed on the substrate, touchdown pressure of an application tip, discharging flow of embedding liquid through a microchannel. By means of calibration experiments, samples may be prepared in a reproducible way from the nanoscale biological specimens, and the samples can be investigated in a standardized and optimized procedure, wherein the results of different samples can be compared with high information content. Note that the calibration experiments typically each include determining an obtained average thickness of the obtained thin film, which is typically measured by electron microscopy in a frozen (or immobilized) state. Experimental parameters in the calibration experiments may be adapted until a desired average film thickness is obtained.

Particularly preferred is a variant wherein the embedding liquid is chosen as water with added salt,

preferred wherein the added salt is NaCl,
particularly preferred wherein the added salt is NaCl with a concentration of 10 mM. By adding salt, a high electrical conductivity of the thin film of (immobilized) embedding liquid may be obtained.

In a preferred variant, the substrate is a graphene foil or carbon foil. Graphene foils or carbon foils provide a good electric conductivity for providing a good electron transfer from the thin film (or the specimen within the thin film) via the substrate to a substrate holder / sample holder and finally to earth, and therefore help to minimize radiation damage. Further, the graphene foil or carbon foil is well suited for TEM investigation, and in particular for transmission by an electron beam without distorting the TEM image of the imaged specimen too much. Note that the graphene foil or carbon foil is typically very thin, such as with a thickness of 5 nm or less, in particular wherein the graphene foil may be a monoatomic film. Typically, such a very thin graphene or carbon foil is supported by a stronger film having holes (for example a holey film with a thickness of 50 nm or more), such as a carbon film with holes or a silicon nitride membrane with holes.

Further advantageous is a variant wherein before step b) the substrate is treated with a plasma at least in the area of one or more application zones, preferably wherein the plasma is formed from oxygen and/or argon, most preferably wherein the plasma is formed from oxygen and/or argon at a pressure of 10$^{-3}$ mbar. The plasma can make the substrate hydrophilic, at least in the application zone/zones of the substrate where the embedding liquid will be applied. Further, the plasma treatment cleans the substrate surface.

In an advantageous variant, after step b) and before step c), the thin film of the embedding liquid is covered with a covering substrate, in particular wherein the covering substrate is a graphene foil or a carbon foil. The covering substrate can help to obtain small liquid pockets and/or minimize evaporation of (a fraction of) the embedding liquid of the thin film in the vacuum of the electron beam instrument in step d). Further, in case of an electrically conductive cover substrate, the covering substrate can improve electron transfer from the thin film to the substrate holder / sample holder and finally to earth, and thus helps to minimize radiation damage.

In another advantageous variant, the embedding liquid contains electrically conductive polymers and/or electrically conductive proteins. The electrically conductive polymers and/or electrically conductive proteins improve the electron transfer from the nanoscale biological specimen investigated to the substrate and the substrate holder / sample holder and finally to earth, and thus help to minimize radiation damage in step d). Note that an electrically conductive polymer (or protein) can at the same time function as a linker molecule.

Preferred is a variant wherein the embedding liquid contains negative stain, in particular wherein the negative stain is chosen as α-D-Glucose 1-phosphate dipotassium salt hydrate, applied preferably with a concentration of 2 mM. The chemical stain may preserve the structure of the nanoscale biological specimen, in particular by maintaining a molecular layer of water around the specimen. The stain may further provide electrical conductivity to the substrate or the substrate holder / sample holder and finally to earth, thus minimizing radiation damage. By applying a negative stain, a thin film stable in the vacuum of the electron beam instrument can be obtained without a cover substrate. Typically, the thin film is gel-like at measurement temperature MT. In this variant, typically the amount of the embedding liquid is reduced applying evaporation in step b), in particular at least at the end of the reducing procedure.

Particularly preferred is a variant wherein in step c), the thin film on the substrate is first cooled down to a low temperature LT, with LT≤-196°C, and then warmed up again to the measuring temperature MT. Typically the first cooling down is done at a high cooling rate, such as within 240 s or less, or even 120 s or less (assuming a preparation temperature PT between 0°C and 40°C). By the first cooling down (at a cooling rate high enough), the embedding liquid of the thin film can be transformed into amorphous ice, without forming ice crystals. The later warming up to the measurement temperature MT, even with MT above the glass transition temperature of the embedding liquid, will not lead to crystallization of the embedding liquid of the thin film due to its low film thickness. Note that the low temperature LT is at or below the boiling temperature of liquid nitrogen (LN2) at 1 bar.

In an alternative variant, during steps b) through d) the temperature of the thin film is always kept above or at the measurement temperature MT. This simplifies and accelerates the sample preparation procedure. In particular, only moderately low temperatures need to be provided for, which in general can be provided without handling of cryogen liquids such as LN2 or LHe and with inexpensive equipment.

Further preferred is a variant wherein the substrate is placed on a TEM grid, with the TEM grid having a plurality of crossing grid bars defining grid windows between the crossing grid bars. Each grid window may be used as an application zone. The TEM grid simplifies sample handling in a TEM. Further the TEM grid, which is typically made of copper, provides good electrical conduction paths.

A preferred further development of the above variant provides that during step b), embedding liquid is initially applied as a drop spreading over a plurality of grid windows, in particular all grid windows of the TEM grid. Typically, some embedding liquid is removed then, for example by blotting, preferably wherein the TEM grid is pressed onto a filter paper. This is particularly fast and reliably wets all grid windows or respective application zones with the embedding liquid.

A particularly preferred variant provides that the substrate is placed on a TEM grid, with the TEM grid having a plurality of crossing grid bars defining grid windows between the crossing grid bars, and that during step b), embedding liquid is applied between grid bars in at least one grid window,

in particular wherein embedding liquid is applied deliberately between the grid bars in the at least one grid window. The grid bars can form a (maximum) limitation of the application zones. The grid windows or the respective application zones are easy to spot in the electron beam instrument, and accordingly the nanoscale biological specimens there are easy to investigate. The TEM grid, which is typically made of copper, further provides good electrical conduction paths along the grid bars. In case of application of small volumes SV of embedding liquid, a respective small volume SV of embedding liquid can easily be placed onto a respective grid window, in particular centrally.

In a preferred variant, the substrate comprises at least one local coating defining at least one application zone, wherein the local coating provides that the substrate is wettable for the embedding liquid in the application zone. By means of the local coating, the application zone can be well defined, in particular its area or extension. Further, originally unsuitable substrate materials for being wetted by the embedding liquid can be made suitable by the local coating. This enlarges the scope of substrate materials for the invention. The local coating can in particular be made from linker molecules (see below).

An advantageous variant provides

that the substrate is at least partially coated with linker molecules for linking the nanoscale biological specimens to the substrate,
in particular wherein the nanoscale biological specimens are proteins and the substrate comprises a graphene foil,
that the linker molecules attach on one side to the substrate via a non-polar chemical group or groups, in particular wherein the non-polar chemical group or groups are based on pyrene, pyridine, porphyrin, or amine,
and that the linker molecules on their other side have a polar group or polar groups, in particular wherein the polar group or groups comprise butanoic acid-succinimidyl ester, pyrenebutyric acid (PBA) or carboxyl. The linker molecules allow a coating of the substrate, and in particular a local coating of the substrate an thus a local preparation of application zones for the embedding liquid. The linker molecules may mediate between a non-polar substrate surface and a polar embedding liquid containing the nanoscale biological specimens. The linker molecules may extend, with their polar groups, into the embedding liquid which is a polar liquid, in particular wherein the polar liquid is based on water. The polar groups of the linker molecules may directly bind to side chains of the nanoscale biological specimens, in particular by building hydrogen bonds.

In a preferred further development of the above variant, the linker molecules contain an electrically conductive chain, in particular wherein the electrically conductive chain is based on carbon atoms with unsaturated carbon bonds or a carotenoid or a chain of carbon atoms with oxygen atoms. In this way, the electron transfer from the thin film or the nanoscale biological specimens to the substrate may be improved, and thus radiation damage may be minimized.

Also preferred is a further development of the above variant wherein the linker molecules comprise molecules for specially binding to the nanoscale biological specimens to be investigated, in particular wherein the nanoscale biological specimens comprise a protein, an antibody, a binding peptide, a DNA sequence, a ligand for a receptor, a chelated metal, or a histidine. Said molecules have a high affinity for binding to the nanoscale biological specimens to be investigated are also called ligand molecules here. Various compounds (containing a ligand molecule and a nanoscale biological specimen) exist depending on the biological substance (that is nanoscale biological specimen) to be investigated. For example, linker molecules may contain biotin that is a ligand for the protein streptavidin, and the compound with attached linker molecule is Amine-PEG2-Biotin.

Also within the scope of the present invention is a method for determining a flux threshold of electrons for measuring of a nanoscale biological specimen with an electron beam, comprising the following steps:

step $\alpha$) investigating a first nanoscale biological specimen according to the inventive method described above, wherein in step d) the first nanoscale biological specimen is exposed to a preselected electron dose at a first flux of the electrons, and a structure of the first nanoscale biological specimen is detected,
Step $\beta$) investigating a further nanoscale biological specimen according to the inventive method as described above, wherein in step d) the further nanoscale biological specimen is exposed to the preselected electron dose at a further flux of the electrons being higher than the previously applied flux of the electrons, and a further structure of the further nanoscale biological specimen is detected,
Step $\gamma$) repeating the procedure of step $\beta$) until the structure of the nanoscale biological specimen becomes distorted, thereby determining the flux threshold of electrons.

In the course of the method, it is determined what electron flux the chosen nanoscale biological specimens can just stand in the electron beam instrument at the chosen electron dose, before the molecular structure becomes distorted as visible from, for example, changes of the original TEM image or diffraction pattern. Note that several series of measurements according to steps $\alpha$) through $\gamma$) can be performed for corresponding several different electron doses. Investigations of the nanoscale biological specimen just below the determined flux threshold will result in an optimum spatial resolution of sample investigation in the electron beam instrument. The flux at which the structure becomes distorted may be identified, for example, by a disappearing of diffraction peaks at higher spatial frequencies, or the TEM image becoming fainter, indicating mass loss of the (diffracting) protein. Aiming for a specific spatial resolution, for example, 4 Å, structural damage is identified when diffraction signals above a certain spatial frequency disappear, for example, 1/4 Å aiming for a spatial resolution of 4 Å. Structural damage may be concluded when the relative measure of mass reduces by, for example, 20% or more compared to the first image in an image series. A relative measure of mass is the integrated signal of image pixels at the location of the protein from which is subtracted the integrated signal of image pixels surrounding the protein. A good flux of electrons to start with is 0.5 electrons per $Å^2$ and per s. Flux may be doubled from step to step, for example.

In a preferred variant of the above method for determining the flux threshold, the preselected electron dose is at least 50 electrons per $Å^2$, preferably at least 200 electrons per $Å^2$. These electron doses can be tolerated well in accordance with the invention without significant radiation damage, and lead in general to a good resolution of the nanoscale biological specimens investigated.

Particularly preferred is an inventive method for investigating at least one nanoscale biological specimen as described above, wherein in step d) the nanoscale biological specimen is exposed to an electron dose and a flux of electrons, wherein the flux of electrons is below a flux threshold determined for that electron dose as preselected electron dose in an inventive method for determining a flux threshold as described above. Then the investigation of the nanoscale biological specimens leads to excellent spatial resolution, in particular TEM image resolution, often at 0.5 nm or better (lower), and accurate structure analysis is available within short time, without significant radiation damage to the sample. A typical flux threshold for reduced radiation damage is 10 electrons per $Å^2$ and per s.

A sample for investigating at least one nanoscale biological specimen in an electron beam instrument, with the sample comprising:

-  an electrically conductive substrate, in particular a graphene foil or a carbon foil arranged on a TEM grid,
-  a thin film of an immobilized embedding liquid on the substrate in an application zone,

wherein the immobilized embedding liquid contains a plurality of the nanoscale biological specimens, with MD being a maximum diameter of the nanoscale biological specimens and MD $\leq$ 30 nm,
wherein the thin film has an average thickness AT, with AT $\leq$ 30 nm,
wherein the substrate is wettable for the embedding liquid in the application zone, and wherein the sample is at a measurement temperature MT,
with -100°C$\leq$MT$\leq$-1°C,
may be prepared in accordance with steps a) through c) of an inventive method for investigating at least one nanoscale biological specimen as described above. A sample prepared this way can stand higher radiation doses / electron doses without being damaged. The measurement temperature is high enough to allow an improved electron transfer within the nanoscale biological specimen and through the thin film, and at the same time the measurement temperature is low enough to provide a reduced diffusion of chemical radicals and free electrons through the thin film towards the nanoscale biological specimen. The embedding liquid of the thin film is immobilized by tempering the thin film or its embedding liquid to the measurement temperature MT. Typically, the measurement temperature is below a freezing temperature of the embedding liquid in bulk, but no ice crystals form in the thin film due to its small thickness. Further note that typically, $AT \leq MD$.

Further within the scope of the present invention is the use of a sample preparation apparatus in an inventive method for investigating at least one nanoscale biological specimen as described above, wherein the sample preparation apparatus is adapted to automatically perform at least step b), and preferably also step c). With the sample preparation apparatus used according to the invention, simple sample preparation as well as fast and accurate sample investigation may be achieved.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

Detailed description of the invention and drawing

The invention is shown in the drawing.

Fig. 1     shows a schematic overview over the course of the inventive method;

Fig. 2     shows schematically a part of a thin film in cross section, after step c) of the inventive method in an exemplary variant, wherein the thin film is placed on a substrate;

Fig. 3     shows schematically a part of a thin film in cross section, after step c) of the inventive method in an exemplary variant, with the thin film having a covering substrate;

Fig. 4     shows a diagram plotting the electrical conductivity (upward axis) versus temperature (rightward axis) for water and saline of various concentrations;

Fig. 5     shows a TEM image of a several hemocyanin proteins as nanoscale biological specimen prepared in a thin film containing negative stain, prepared and measured in accordance with a variant of the inventive method, with a measuring temperature of -14°C;

Fig. 6     shows in schematic perspective view the preparation of a thin film in step b) in a variant of the inventive method, using a micro channeled tip for placing a droplet of embedding liquid on a sample in partial picture (a) left, and removing some embedding liquid by blotting, wherein the TEM grid is pressed on a filter paper in partial picture (b) right;

Fig. 7     shows schematically the preparation of Fig. 6 in schematic cross-section in subsequent partial pictures (a) through (d);

Fig. 8     shows in a schematic cross-section the preparation of a thin film in step b) in a variant of the inventive method, wherein some embedding liquid is evaporated;

Fig. 9     shows in a schematic cross-section the preparation of a thin film in step b) in a variant of the inventive method, wherein a small volume of embedding liquid is deliberately placed in an application zone defined by TEM grid bars, in three subsequent partial pictures (a) through (c);

Fig. 10     illustrates schematically an exemplary measurement setup for use in the inventive method, in particular in steps c) and d) of the inventive method;

Fig. 11     shows transmission electron microscopy images of hemocyanin in thin films prepared according to steps a) and b) and tempered and measured at different measurement temperatures, selected from a dose series of up to 1000 electrons per Å$^2$ at -14 according to the invention (top), at room temperature (middle), and at -180 °C (bottom).

Fig. 12    shows a diagram of normalized TEM image intensities (upward axis) of samples prepared according to steps a) and b) and tempered and measured at three different measurement temperatures, plotted over cumulative electron dose (rightward axis);

Fig. 13    shows schematically a part of a thin film in cross section, after step c) of the inventive method in an exemplary variant, wherein a nanoscale biological specimen, here a protein, is fixed on the substrate by linker molecules;

Fig. 14    shows in schematic cross-section the preparation of thin films on a substrate in step b) of the inventive method, in a variant using local coatings, in three subsequent partial pictures (a) through (c);

Fig. 15    shows in schematic cross-section the preparation of a thin film on a substrate in step b) of the inventive method, in a variant using an application tip, such as an AFM tip, and a supply pool for the embedding liquid, with two subsequent partial pictures (a) and (b).

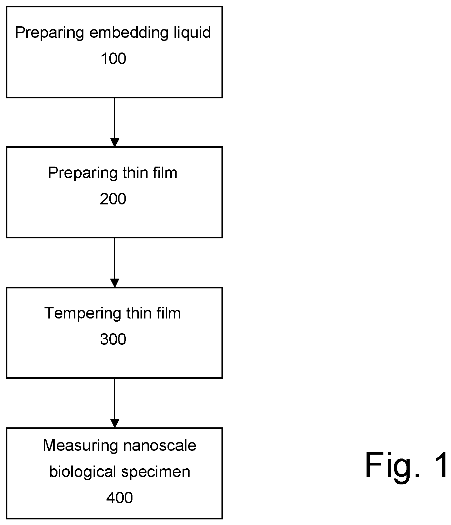

The present invention suggest, as can be seen from the schematic diagram of **Fig. 1,** a method for investigating nanoscale biological specimens in a four step process. In a first **step a),** see ref. 100, an embedding liquid is prepared which contains the nanoscale biological specimens. For this purpose, the specimens can be put into a solvent, or a solvent can be put onto the biological specimens, for example. A typical solvent is saline. The biological specimens to be investigated have a maximum diameter MD of 30 nm or less, often 20 nm or less. The solvent is typically based on water. In a second **step b),** a thin film of the embedding liquid is prepared on an electrically conductive substrate, see ref. 200. The embedding liquid is wetting for the substrate. The substrate may comprise graphene for example. Often, a large initial amount/volume of embedding liquid, that is more than needed for the thin film, may be deposited on the substrate first, and then excess liquid is removed to obtain the thin film, or an initially small amount/volume of embedding liquid may be deposited to obtain the thin film directly. The thin film of embedding liquid, at least at the end of step b), has an average thickness AT of 30 nm or less, and often 20 nm or less. In a next **step c),** see ref. 300, the thin film is tempered to a measurement temperature MT with -100°C≤MT≤-1°C, and preferably -50°C≤MT≤-1°C. Often, this temperature is directly set by cooling to MT; alternatively, this temperature may be set by first cooling the sample below MT and warming it up again to MT. Finally, in a **step d),** see ref. 400, the thin film is investigated in an electron beam instrument, such as a TEM, at temperature MT.

In one aspect of this invention it is proposed to mount a nanoscale organic object, for example, a protein or a virus particle, on a sample support in such a way that electron transfer between the object and the sample support is possible, wherein first it is suggested to apply the object within a liquid (also called embedding liquid), to then reduce the liquid thickness to a very thin liquid layer (also called thin film) at the sample support, and to then freeze (cool) the sample to a temperature below freezing point of the embedding liquid in bulk, whereby the thickness of the liquid layer is below the minimum thickness required for ice crystal formation, and the temperate of said layer is sufficiently high such that electron transfer still takes place. The sample is then examined in the vacuum environment of an electron beam instrument at an electron flux below the threshold for radiation damage by ionization, whereby the total dose can be increased above 10 e$^-$ Å$^2$.

The sample support is mounted in a sample holder with means for cooling and measuring the temperature, which is commercially available as a so-called cryo holder for TEM specimens. The sample is prepared from an ultra-thin layer of liquid embedding the object immobilized at a surface of a thin membrane, for example, of graphene or carbon. The object is, for example, a protein.

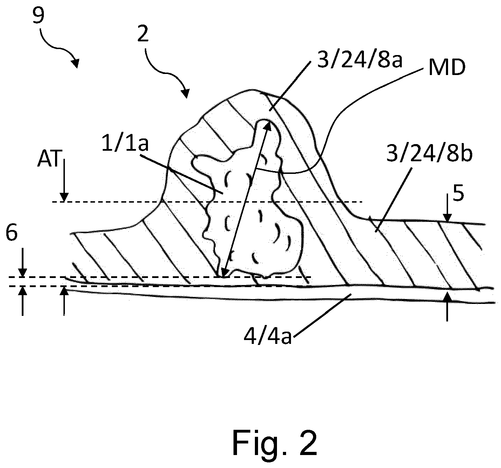

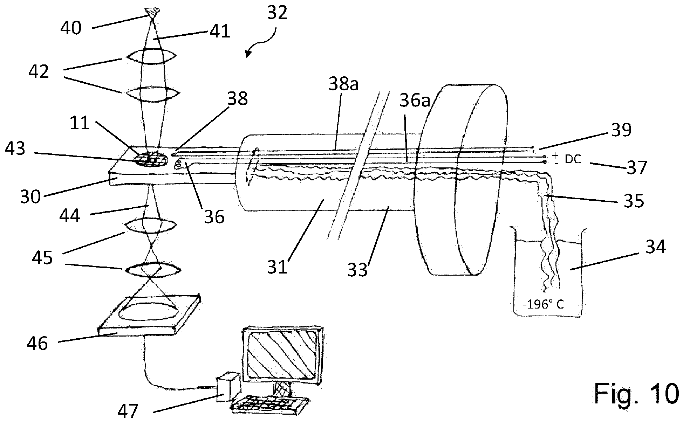

**Fig. 2** shows a section of a thin film 2 after step c) of the inventive method in an exemplary variant. A nanoscale biological specimen 1, here a protein 1a, is embedded in a thin film 2 (also called thin layer) of an immobilized embedding liquid 3. The immobilized embedding liquid 3 is here cooled water mixed with negative stain 24 of low atomic number; the thin film 2 is for example at a temperature (measurement temperature) of -14°C. The thin film 2 is mounted on a substrate 4 belonging to a sample support, wherein the substrate 4 is chosen as a thin membrane of graphene (also called graphene foil) 4a here. The immobilized embedding liquid 3 covers the protein 1a, see region 8a, and covers the substrate 4 in the vicinity of the protein 1a, see region 8b. The layer thickness 5 at the substrate 4 in region 8b, in the example shown, is smaller than 5 nm such that ice crystal formation is prevented. The protein 1a is here at close distance 6 of 1 - 2 nm to the substrate 4 such that electron transfer between protein 1a and the substrate 4 takes place with sufficient rate to allow charge compensation during irradiation by an electron beam (electron beam not shown, but compare Fig. 10) at low electron flux (<10 electrons per Å$^2$ per s). Further note that the maximum diameter MD of the nanoscale biological specimens 1 and the average thickness AT of the thin film 2 are both 30 nm or less, here with AT≤MD, and in the example shown with about MD=10 nm and AT=5 nm. Note that the thin film 2 on the substrate 4 can be used as a sample 9 for measuring at least one of the nanoscale biological specimen 1 in an electron beam instrument.

The preparation protocol, the wetting behavior of the thin membrane, and the chemical content and thickness of the liquid layer are chosen such that 1) the liquid forms a thin layer over the object upon exposure of the sample to vacuum such to protect the structure of the object, 2) the liquid provides electrical conductance between object and sample support, and 3) ice crystallization does not take place upon freezing even though the temperature is above the glass transition temperature.

In one possible embodiment of the method, the sample is prepared by placing a droplet of $0.2$ $\mu l$ volume of saline with dissolved protein, for example, hemocyanin on a supporting membrane consisting of a single layer of graphene on a holey carbon film mounted in a standard 3 mm gold grid for TEM. After a waiting time of a few minutes, a major fraction of excess liquid is removed by blotting with a filter paper until the surface appears dry but with a shiny (light reflecting) appearance, indicating the presence of a thin liquid film. The sample is then covered with a thin membrane consisting of a single layer of graphene.

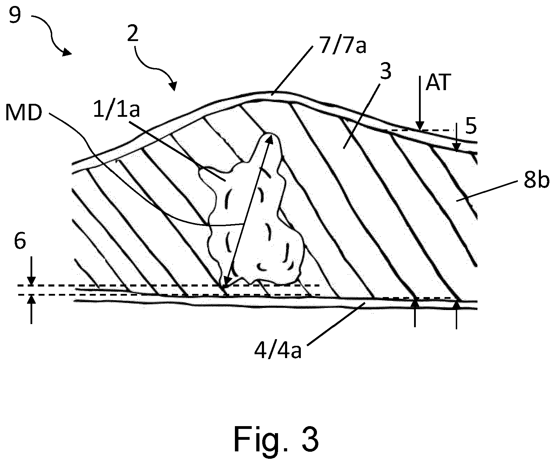

**Fig. 3** shows a section of a thin film 2 after step c) of the inventive method in a corresponding exemplary variant. A nanoscale biological specimen 1, here a protein 1a, is embedded in a thin film (or thin layer) 2 of an immobilized embedding liquid 3, which is here a cooled water mixed with NaCl; the thin film 2 is for example at a temperature (measurement temperature) of -14°C. The thin film 2 is mounted on a substrate 4 belonging to a sample support, wherein the substrate 4 is chosen as a thin membrane of graphene (graphene foil) 4a here. The sample 9 is covered by a covering substrate 7, here a second layer of graphene (or graphene foil) 7a. The layer thickness 5 of the cooled water layer (or immobilized embedding liquid 3) in a region 8b adjacent to the protein 1a is here about 10 nm. The protein 1a is here at close distance 6 of 1 - 2 nm to the substrate 4 such that electron transfer between protein 1a and the substrate 4 takes place with sufficient rate to allow charge compensation during irradiation by an electron beam (electron beam not shown, but compare Fig. 10) at low electron flux (<10 electrons per $Å^2$ per s). The maximum diameter MD of the nanoscale biological specimens 1 and the average thickness AT of the thin film 2 are both 30 nm or less, here with AT≤MD, and in the example shown with about MD=10 nm and AT=10 nm.

The sample, after having been covered with the second graphene layer, is inserted into the vacuum chamber of the electron beam instrument by means of a TEM specimen holder. Upon exposure to vacuum, some excess liquid evaporates but a layer of liquid remains enclosed between both graphene membranes. Note that after the final thickness of the thin film has been reached, the sample is cooled to the measuring temperature, so the embedding liquid becomes immobilized.

In particular, blotting and/or evaporation is done under calibrated conditions, preferably such that the (average) liquid layer thickness becomes thinner than the size of the protein and forms a surface layer at the supporting thin membrane, whereby the layer becomes so thin that ice crystals do not form upon freezing. Calibrated conditions involve humidity of surrounding air, time of blotting, pressure of blotting, type of liquid adsorbing medium. Calibration is done by executing the blotting for a set of conditions and examining the sample via electron microscopy to measure the thickness of the sample and inspect for the presence of ice crystals. Considering pure water, the nucleation rate for ice nucleation is $10^{14}$ $m^{-3}s^{-1}$. A nanodroplet of 2.4 nm in radius would exhibit a reduced ice nucleation rate of $10^6$ $m^{-3}s^{-1}$ (T. Li et al, Nat. Commun. 4 (2013) 1887-1-6). Ice nucleation is altogether avoided for nanodroplets placed on a flat surface (Xiang-Xiong Zhang et al., J. Chem. Phys. 141 (2014) 124709). Thus, ice crystals would not form in a water layer of a thickness of about 3 nm at a surface of a graphene film as sample support. In practice, the liquid layer can be somewhat thicker (e.g. 5 nm) if the embedding liquid applies not pure water but saline, for example, water mixed with $Na^+Cl^-$, which reduces the nucleation for crystallization compared to ice, so that a thicker layer still does not crystallize. In addition, the ice nucleation rate is reduced since the liquid is enclosed between two sheets of graphene providing a mechanical barrier against ice crystal formation.

The sample is then slowly brought to a temperature (measurement temperature) just below the freezing point of the sample, that is below the freezing point of the embedding liquid in bulk. Note that this state is sometimes referred here to as "frozen", even though no ice crystals form due to the small thickness of the thin film formed by the embedding liquid on the substrate.

The temperature (measurement temperature) of the tempered/cooled sample needs to be chosen according to three criteria. 1) The liquid surrounding the object has to be immobilized, typically by choosing the measurement temperature below the freezing point of the embedding liquid in bulk. 2) The temperature needs to be sufficiently high to allow electron transfer to take place in the object of interest, for example, a protein. 3) The temperature needs to be sufficiently high to allow electron transfer between object and sample support.

To fulfil criteria 1, a temperature below 273° K (=0°C) would be needed to ensure freezing of the thin aqueous liquid layer at ambient pressure. The temperature depends on the presence and concentration of saline. For a liquid containing a physiological concentration of NaCl of 100 mol/l (6% by weight), the freezing temperature would be about 269° K (Wikipedia page saline water, https://en.wikipedia.org/wiki/Saline water, downloaded on 22.09.2023). To allow for some tolerance in the exact freezing point, a temperature (measurement temperature MT) of 260° K may be chosen. The latter temperature would still fulfil criteria 2 for typical values of driving force $\Delta G^0$ = -1.5 eV, and $\lambda$ = 0.75 eV since it would allow electron transfer in the protein, for which the electron transfer rate would reduce by a factor of 2 only compared to room temperature.

For charge transfer between the nanoscale biological specimen and sample support, one method is to mount the specimen as close as possible to the sample support, and the temperature is chosen such that electron transfer between the object and the sample support takes place. As an example, one may consider a spherical protein of a diameter of 50 Å receiving an electron flux of 10 e⁻Å⁻²s⁻¹ from the electron beam, and thus a current of $10 \text{ e}^-\text{Å}^{-2}\text{s}^{-1} \times \pi(50\text{Å}/2)^2 = 2\times10^4 \text{ e}^-\text{s}^{-1}$, corresponding to about $3\times10^{-15}$ A.

As an example, one may assume an ideal case of a free electron created in the protein's surface at a distance of 10 Å from the supporting layer providing electrical neutral. The electron transfer rate between a donor and acceptor spaced at this distance in a protein is of the order of $10^9$ s⁻¹ (C.C. Moser et al., Nature 355 (1992) 796), sufficient for charge compensation by 5 orders of magnitude, and so criterion 3 would be fulfilled.

To further enhance electrical conductivity of the sample, a second method for charge transfer between object and sample support is by including ions in the liquid surrounding the object. The measurement temperature is then chosen such that the thin film with ions is still electrically conductive, fulfilling criterion 3. Doping ice with NaCl of 7 μM increases the conductivity towards $\sigma = 2\times10^{-5}$ Ω⁻¹m⁻¹ at freezing point compared to pure ice (G. W. Gross et al., J. Glaciol. 21 (1978) 143, or see also Stillman and Grimm, Lunar and Planetary Science XXXIX (2008) 2277).

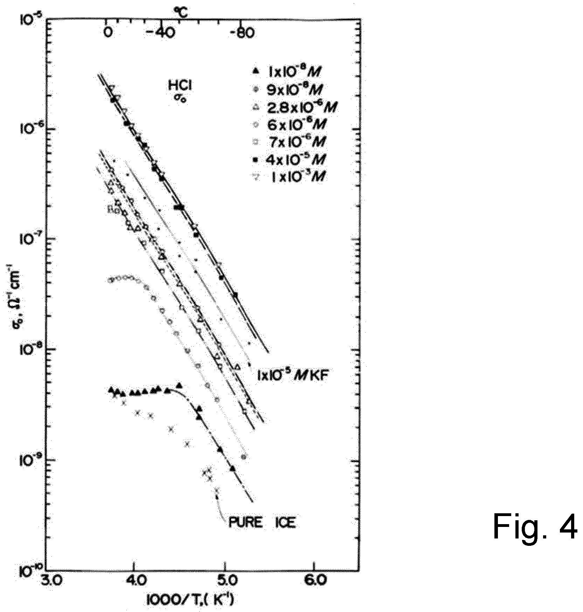

**Fig. 4,** taken from G. W. Gross et al., J. Glaciol. 21 (1978) 143, illustrates the static conductivity of ice grown from different NaCl solutions as function of temperature compared with pure ice. Pure ice (crosses x) exhibits an electrical conductivity $\sigma = 4\times10^{-9}$ Ω⁻¹cm⁻¹ at freezing point (0°C, see scale in the top of the diagram). Ice grown from a solution of NaCl of 0.1 mM in water gives a concentration of NaCl of 7 μM in ice, exhibiting an increased conductivity of $\sigma = 2\times10^{-7}$ Ω⁻¹cm⁻¹ at freezing point (open squares).

The effect of doping on charge transfer can be estimated as follows. Suppose a protein is surrounded by a layer of mixed ice of thickness t =20 Å and positioned on a conductive support at electrical neutral. Suppose the current from the protein to the support would take the shortest pathway and pass through an area $A = \pi(50 \text{ Å}/2)^2$. Thus, a resistive path is obtained with a resistance $R = t/(A\sigma)$. For ice mixed with NaCl, $R = 5\times10^{12}$ Ω. The emission of secondary electrons from the sample upon electron beam irradiation can be considered as electrical source that is connected via the resistance presented by the mixed ice layer between the protein and the support connected to electrical neutral. With $I = 3\times10^{-15}$ A at electron flux of 10 e⁻Å⁻²s⁻¹ received by the protein, the potential drop over the mixed ice layer amounts to $U = IR = 1.6\times10^{-2}$ V. The corresponding electric field strength would then reach $F = 8\times10^6$ Vm⁻¹, which is below the dielectric strength of ice of $8\times10^7$ Vm⁻¹ (T. Kohno et al., IEEE Transactions on Electrical Insulation, EI-15 (1980) 27) and so the electrical circuit would function. If on the other hand, no doping was used, the system would reach $F = 10^9$ Vm⁻¹, which would be above the dielectric strength, and so sample damage would occur, typically by the generation of bubbles of hydrogen gas.

The thus obtained sample conditions provide the object embedded in a thin frozen immobilizing layer while being electrically conductive such to optimize radiation damage mitigation.

For obtaining structural information of the sample, electron beam exposure in transmission mode is preferred, such that an electron dose efficient contrast mechanisms can be applied, for example, phase contrast, diffraction, holography, or ptychography.

The inventive method largely reduces the problem of electron beam damage for a broad class of radiation sensitive samples such as proteins, virus particles, (bio)minerals, polymers, soft-matter nanoparticles, electrolytes, etc. With an increased tolerance to radiation damage, it is possible to achieve a better spatial resolution for these samples compared to state-of-the-art.

Various other embodiments of this method are possible of which examples are described in the following.

The blotted sample may be frozen (cooled) slowly to a temperature of 260° K in an atmosphere with low water vapor content provided by dry nitrogen gas such that freezing does not lead to condensation of ice on the sample. The sample is then inserted into vacuum.

The blotted sample may, in an alternative, be frozen (cooled) sufficiently fast and to a sufficient low temperature (also referred to as low temperature LT, typically with LT≤-196°C) to obtain amorphous ice, and the sample is then inserted into vacuum and carefully heated to a temperature (measurement temperature MT) of, for example, 260° K. The blotting step prior to freezing should be executed in such way as described above, such that a liquid layer of only a few nanometers thickness remains, and thus to prevent ice crystal formation once the sample is heated above the glass transition temperature.

The sample support may comprise of carbon, graphene oxide, silicon nitride, or any other material that provides a mechanically strong support, and provides charge transfer for the conductive substrate. In case transmission of the electron beam is desired, the substrate should be thin enough to allow electron transmission. Thin enough means that the thickness of the substrate material is at least a factor of ten smaller than the mean free path length of elastic electron scattering at the set electron energy, which amounts to approximately 0.12 μm for carbon at 200 keV beam energy (K. Iakoubovskii and K. Mitsuishi, J. Phys. Condens. Matter 21 (2009) 155402). The substrate does not necessarily need to be a flat sheet but may also be curved, for example, a carbon nanotube, or tip shaped.

The method can also be applied correspondingly for thick substrates, in which case backscattered signals or amplified secondary emission signals are used for detection, for example, in scanning electron microscopy.

In yet another embodiment, the substrate is first placed in a controlled environment such as a chamber with pure argon, or a vacuum chamber, and the sample is placed on the substrate in this chamber such to reduce contamination as much as possible.

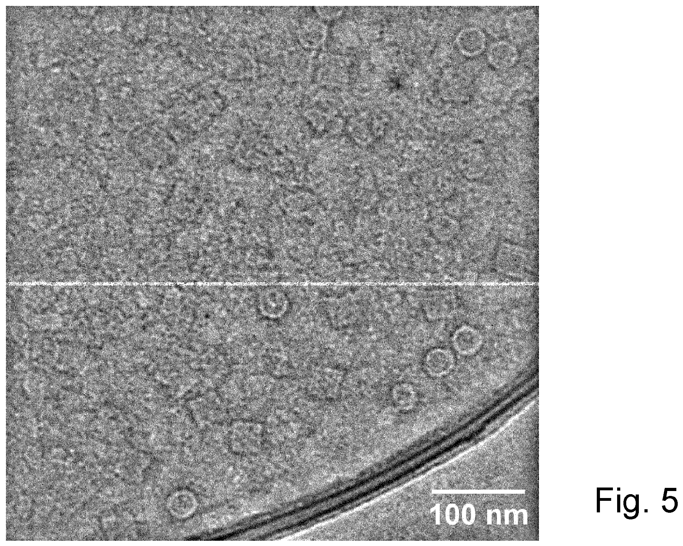

In another embodiment, instead of saline, the object is surrounded by a chemical stain preserving the structure of the biological specimen, for example, a protein or virus particle, and electrical conductance is provided via the presence of ions. An example is a stain of low atomic number materials such as provided by applying water with dissolved glucose-1-phosphate potassium salt. Further, the sample is not covered by a graphene sheet. Upon exposure to vacuum, some excess liquid evaporates but the liquid layer transitions to a gel protecting the structure of the object from being damaged in the vacuum, so that a molecular layer of water remains stable at the protein (see Fig. 2 above). Experiments demonstrated that this embodiment allows to obtain excellent TEM images (see Fig. 5 below), wherein ice crystals are absent from the frozen specimen, and the sample tolerates a high electron dose (sample deformation is not observed for an electron dose in the measured range of up to $10^3$ e⁻Å$^2$)

**Fig. 5** shows a transmission electron microscopy (TEM) image of several hemocyanin proteins of tubular shape in a thin layer of negative stain of low atomic number placed on a graphene layer mounted on a holey carbon film. The protein is visible either as circle or as rectangle depending on the orientation of the protein on the supporting graphene. The edge of the hole in the carbon film is visible at the lower right. The electron flux was 3.5 electrons per Å$^2$ per s with an exposure time of 4 s, giving an electron dose of 14 electrons per Å$^2$. The sample, prepared and measured according to the invention, was kept at a measurement temperature of -14 °C during imaging here.

The embedding liquid used may contain conductive polymers or conductive proteins providing electron transmission pathways.

The embedding liquid used may contain heavy water for additional radiation protection or an ionic liquid with very low vapor pressure for protection of the specimen against evaporation. Another type of liquid than water or saline can be used, for example, an oil or an electrolyte.

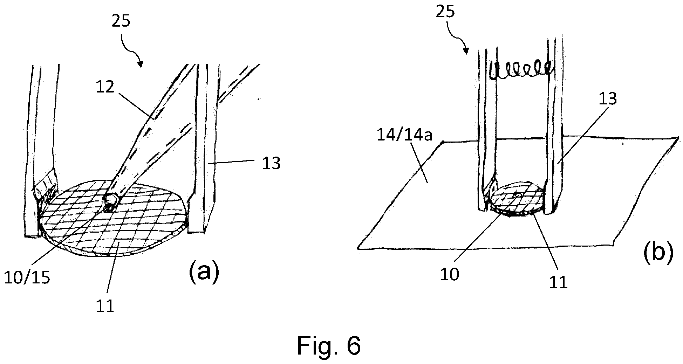

The sample preparation steps are preferably carried out in an automated way by means of a sample preparation apparatus 25, as shown in **Fig. 6.** As illustrated on the left partial picture (a) of Fig. 6, a small liquid droplet 10 containing protein and saline is precisely pipetted at a defined location on a standard 3 mm grid for transmission electron microscopy (TEM grid) 11 by means of a micro pipetting device of which the micro pipetting tip (or application tip having a microchannel) 12 is positioned above the 3 mm grid 11. Note that the liquid droplet 10 represents here an initial large amount 15 of the embedding liquid, more than needed for preparing the intended thin film on the TEM grid 11. The 3 mm grid 11 comprises of a copper frame supporting a holey carbon film, and a graphene membrane covers the middle surface of the carbon film (see also further below). The grid 11 is held in place by a miniature gripper 13. Further, as illustrated on the right partial picture (b) of Fig. 6, to remove excess liquid from the liquid droplet 10 located on the TEM grid 11, the 3 mm grid 11 is carefully pressed against a piece of a liquid absorbing medium 14, here a piece of filter paper 14a, by means of the miniature gripper 13. The micro pipetting tip 12 and the miniature gripper 13 are operated automatically in the sample preparation apparatus 25 by means of one or more robotic arms and an electronic control (not shown in further detail).

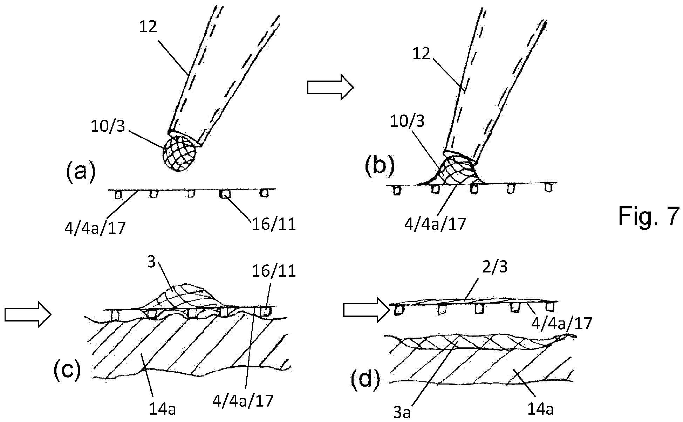

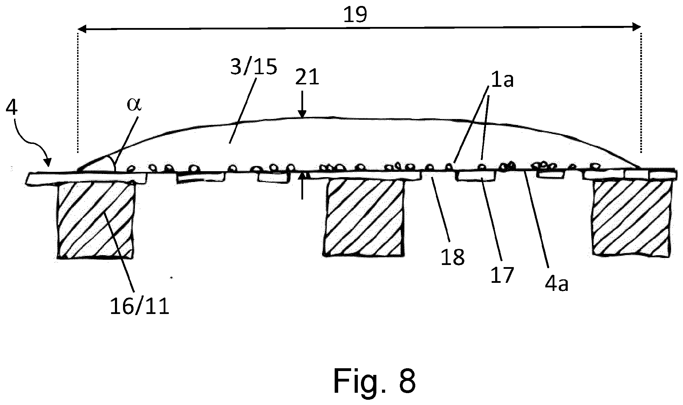

**Fig. 7** illustrates the blotting process in some more detail in schematic cross-sectional view, in four subsequent partial pictures (a) through (d). As shown in partial picture (a), a substrate 4, here a holey carbon foil 17 with graphene foil 4a, is mounted on the grid bars 16 of a 3 mm TEM grid 11. A micro pipette tip 12 applies a liquid droplet 10 of embedding liquid 3, here containing protein and saline, see partial picture (b). The micro pipette tip 12 is lowered to the carbon foil 17 such that the liquid droplet 10 touches the carbon foil 17. The tip 12 is then withdrawn, leaving some embedding liquid 3 at the carbon foil 17 with graphene foil 4a, wherein the substrate surface is wettable for the embedding liquid 3, see partial picture (c). The 3 mm TEM grid 11 is then placed on a piece of filter paper 14a. Some of the embedding liquid 3 flows through small holes (not shown in Fig. 7, but see below in Fig. 8) in the carbon foil 17 and the graphene foil 4a to the bottom of the 3 mm grid 11, and from there to the grid bars 16, from where it is absorbed in the filter paper 14a. The filter paper 14a is then removed, see partial picture (d), thus removing the liquid 3a absorbed in the filter paper 14a, whereas a thinner liquid layer than initially applied, that is a thin film 2 of embedding liquid 3, remains on the holey carbon foil 17 with graphene foil 4a.

A subset of the automated sample preparation for the present invention can be accomplished using commercially available equipment, for example using an apparatus described in US 2004/157284 (=US 7,413,872).

**Fig. 8** illustrates by way of example in some more detail a typical structure of a substrate 4 for use with the present invention, together with a variant of thin film preparation based on evaporation. A carbon foil 17 with holes 18 supports a graphene film (or graphene foil) 4a and is mounted on the grid bars 16 of a 3 mm TEM grid 11. Here, an area of the carbon foil 17 of diameter 19 is covered with an initially large amount 15 of embedding liquid 3 making a contact angle $\alpha$ with the carbon foil 17 supporting the graphene foil 4a. Since the substrate 4 (or the carbon foil 17 and the graphene foil 4a) are wettable for the embedding liquid 3, the wetting angle (or contact angle) $\alpha$ is smaller than 90°, and typically is also smaller than 45°. In the illustrated variant, the (maximum) thickness 21 of the embedding liquid 3 reduces with time due to evaporation. The embedding liquid 3 contains proteins 1a and saline here. Proteins 1a from the embedding liquid deposition accumulate at the carbon foil 17 where they become immobilized in the final thin film (final thin film not shown here, but compare Fig. 2 for example).

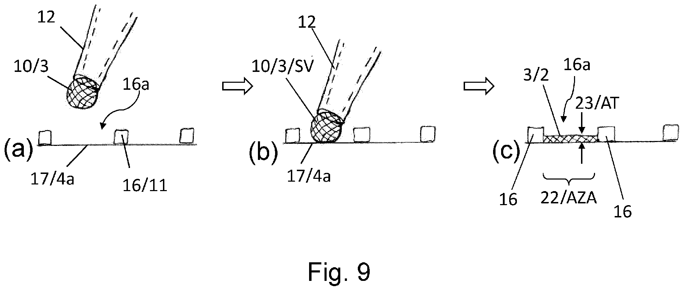

**Fig. 9** illustrates another variant of thin film preparation for the invention, in subsequent partial pictures (a) through (c). As can be seen in partial picture (a), a holey carbon foil 17 with graphene foil 4a is mounted on the grid bars 16 of a 3 mm TEM grid 11. A micro pipette tip 12 applies a liquid droplet 10 of embedding liquid 3, here containing protein in and saline. The tip 12 is made of a pulled glass capillary with a tip diameter smaller than the distance between the grid bars 16 of the 3 mm TEM grid 11 of typically 60 $\mu$m, that is smaller than a grid window 16a to be deliberately filled with the embedding liquid 3. The tip 12 is lowered to the carbon foil 17 such that the liquid droplet 10 touches the foil 17, see partial picture (b). The tip 12 is then withdrawn, leaving some embedding liquid 3 at the carbon foil 17 with graphene, which is wetting for the embedding liquid 3 (for example, due to a plasma treatment). The embedding liquid 3 spreads out in an application zone 22 defined by the grid bars 16 limiting the grid window 16a, leaving a liquid thin film 2 of homogenous thickness 23, see partial picture (c). In the variant shown, the droplet 10 of embedding liquid 3 has an initial small volume SV, which is chosen such that with respect to an application zone area AZA of the application zone 22 over which the small volume SV of embedding liquid 3 spreads, the homogeneous layer thickness 23 (which is at the same time the average thickness AT of the thin film 2 here) is 30 nm or less, preferably 20 nm or less. In this case, the thin film 2 is finished, and no further reduction of the embedding liquid 3 is necessary before proceeding with the tempering step. For a typical 3mm TEM grid 11, SV can be chosen as 36 fL to achieve an AT of 10 nm, for example.

Further automation may be implemented including automated loading of the 3 mm grid in the tip of a specimen holder for electron microscopy. The specimen holder is first mounted in an adapter in the sample preparation apparatus. A mechanical manipulator positions the 3 mm grid in the tip.

The sample preparation apparatus may also contain one or more additional micro pipettes or micro-channeled cantilevers for adding fluids, such as a chemical stain or a liquid droplet containing conductive polymer.

A further addition may be the enclosure of the sample in a controlled environment of, for example, pure argon gas, or the equipment may also be mounted in a vacuum chamber.

In another embodiment, the apparatus contains a freezing device (cooling device), which can be of a type of a rapid plunge freezing.

The sample is placed in an electron beam instrument for investigation of the nanoscale structure of the specimen. Various types of instruments that can be used in accordance with the invention are commercially available, such as a transmission electron microscope, a scanning transmission electron microscope, a scanning electron microscope, or an electron diffraction instrument. The substrate holding the specimen that is mounted, for example, on a 3 mm grid, is placed in the vacuum chamber of the electron beam instrument, for example, by means of a cooling specimen holder, for example, a cryo transfer holder as described in US 2019/131106 or in US 2012/024086. The temperature may be controlled also using a modified electron beam instrument as described, for example, in US 2007/252090. In case a scanning electron microscope is used, the specimen can be mounted on a cooling Peltier stage.

**Fig. 10** illustrates an exemplary measurement setup for measuring a nanoscale biological specimen within a thin film in an electron beam instrument 32, in accordance with the invention. A 3 mm grid 11 containing a holey carbon foil supporting a graphene film with proteins embedded in a cooled liquid is mounted in the tip 30 of a TEM specimen holder of which the shaft 31 is placed in the vacuum chamber of the electron beam instrument 32. The shaft 31 extends outside the vacuum 33 where it is connected to control functions. A reservoir 34 containing liquid nitrogen of temperature -196°C is connected via copper wires 35, which transmit heat through the shaft 31 away from the tip 30 for the purpose of cooling the tip 30. A heating coil 36 is mounted in the tip 30 for the purpose of heating the tip 30 against the cooling such to be able to set a desired temperature (that is to set the measurement temperature MT for preparing and performing the measurement). The heating coil 36 is connected to electric wires 36a to a direct current regulating device 37 outside the electron beam instrument 32. For temperature regulation, the temperature is measured with a thermocouple 38 in the tip 30, wherein the thermocouple 38 is connected to a measurement device 39 outside of the electron beam instrument 32 via further electric wires 38a. An electron source 40 (at an electrical potential of, for example, 200 kV) produces an electron beam 41 that is shaped by (for example) two condenser lenses 42, resulting in an impact area of the electron beam at the specimen (or sample) 43. The transmitted electron beam 44 containing information about the protein in the sample 43 is shaped by (for example) two projector lenses 45 and projected on a camera 46. The camera 46 is controlled and read out by a computer 47 for data acquisition, storage, and initial data processing.

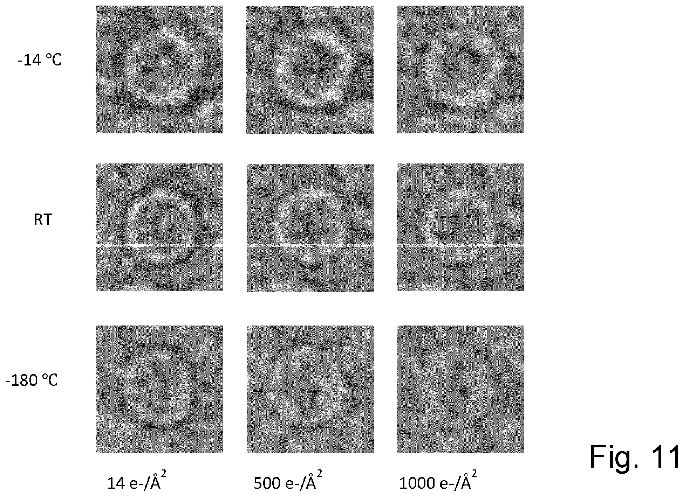

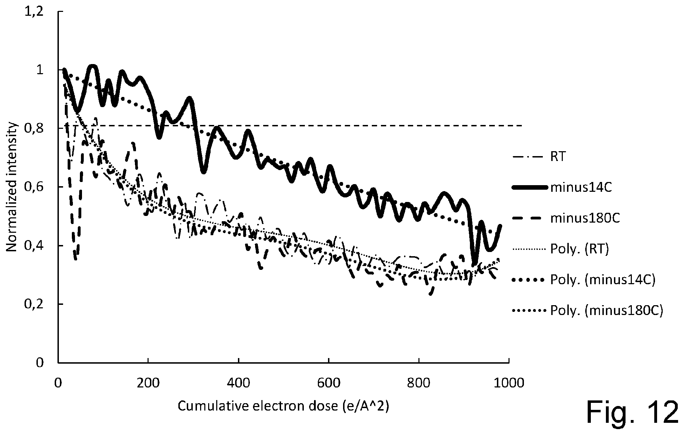

Fig. 11 and 12 illustrate experimental results indicating the advantages of the invention, in particular the tolerance of increased electron doses of samples during measurement. **Fig. 11** depicts transmission electron microscopy images of hemocyanin, selected from a dose series of up to 1000 electrons per Å$^2$ at -14 °C in accordance with the invention (top), and for comparison at room temperature (middle), and at -180 °C (bottom). A high pass filter was applied to filter out the features larger than the protein size and a Gaussian filter (sigma=2pixels) was applied to reduce the pixel noise for each image. While only a small change can be observed in the protein structure between 14 e/ Å$^2$ (first image) and 500 e/Å$^2$ at -14°C, the protein structures at 500 e/ Å$^2$ dramatically changed compared to the first images at room temperature RT and -180C.

**Fig. 12** shows a measurement of radiation tolerance, for illustrating the benefits of the method for investigating nanoscale biological specimens in accordance with the invention. TEM image series were recorded at different measurement temperatures, namely at room temperature (RT), -14 °C, and -180 °C, and subsequently analyzed. The TEM images were similar as the one shown in Fig. 5. For analysis, image areas showing a protein in circular form were selected (compare Fig. 11), and the area image intensity was measured repeatedly after having accumulated a particular electron dose respectively. To obtain the area image intensity, radially integrated pixel intensities were calculated from the center of the proteins, where the maximum pixel intensity corresponded to the densest region of the protein. A normalization was applied by dividing the pixel intensities in the protein region by pixel intensities in the stained region adjacent to the protein. The image intensity of each selected area in the image series was divided by the intensity in the selected area of the first image in the image series to obtain the normalized intensity, which can be used as an indicator for the "remaining integrity" of the protein structure. The normalized intensity was plotted versus the cumulative electron dose received by the sample. For analysis of the radiation tolerance, trendlines (polynomial fitting curves, see dotted lines) were fitted to the experimental curves, and the intercept was determined with the relative intensity of 0.8. The maximal cumulative electron dose for which the relative intensity remained above 0.8 was used as the criterion of the maximal electron dose the sample could tolerate. The largest maximal dose of 300 electrons per $Å^2$ was determined for the sample at - 14 °C, while the samples measured at both other temperatures (RT and -180°C) tolerated a maximum of 60 electrons per $Å^2$ only. Setting the measurement temperature of the sample at -14 °C, in accordance with the invention, thus increases the electron dose tolerance by a factor of 5 as compared to both other temperatures.

Analogously to the TEM images of dose series described above, for a particular preselected electron dose, TEM images of a flux series can be recorded in accordance with the invention. In each TEM image, a different electron flux is applied, wherein the preselected electron dose is distributed over different irradiation/measurement times. For each flux, a different position on the sample (and therefore a different nanoscale biological specimen/protein) is chosen. A typical flux series starts with a low electron flux, such as 1 e/($Å^2$*s), and flux is doubled from image to image in the series, such as to 2 e/($Å^2$*s), 4 e/($Å^2$*s), 8 e/($Å^2$*s) and so on. The image of the sample measured with the highest flux that maintained its protein structure (that is the structure is not yet distorted) is determined. Note that the series can be ended once the first structure distortion has been identified.

Structure distortion can be determined for example using the 0.8 normalized intensity criterion described above (see Fig. 12). Structure distortion is directly visible in the TEM images; as an example, in the dose series above (see Fig. 11), in structure distortion could be clearly observed in the -180°C series in the images of 500 e/$Å^2$ and of 1000 e/$Å^2$ image, as compared to the 14 e/$Å^2$ image at this temperature; structure distortion in a flux series is visible the same way. Note that various ways to identify structure distortion may be applied, for example analyzing contrast of the structure, diameter of structure, and many more.

For future measurements for samples of this type and the preselected electron dose, said highest flux having maintained the protein structure can be chosen, to efficiently obtain good quality TEM images.

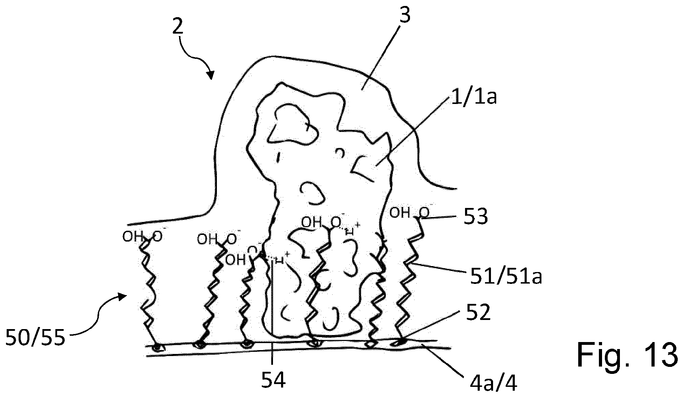

**Fig. 13** shows a part of a thin film 2 after step c) of the inventive method in an exemplary variant, wherein linker molecules 55 are applied. The thin film 2 of Fig. 13 is similar to the thin film shown in Fig. 2, so above all the differences are further described. In the variant shown in Fig. 13, a protein 1a adhered to a supporting thin membrane of graphene 4a is covered with an ultra-thin cooled layer of an embedding liquid 3. A conductive polymer 50 with unsaturated carbon bonds 51a is attached to the supporting graphene foil 4a via a non-polar group (here an aromatic group) 52, and has a polar group (here a carboxyl group) 53 for adhering to the protein 1a by forming an H-bond 54 to a side chain of the protein 1a. The conductive polymers 50 act here as linker molecules 55, wherein the linker molecules 55 improve adherence of the protein 1a to the substrate 4 by mediating between the non-polar substrate 4 and the polar protein 1a (and the polar aqueous embedding liquid 3). The unsaturated carbon bonds 51a form a conductive chain 51 providing some electric conductivity, so electron transfer between the substrate 4 and the protein 1a is enhanced, what helps to reduce radiation damage.

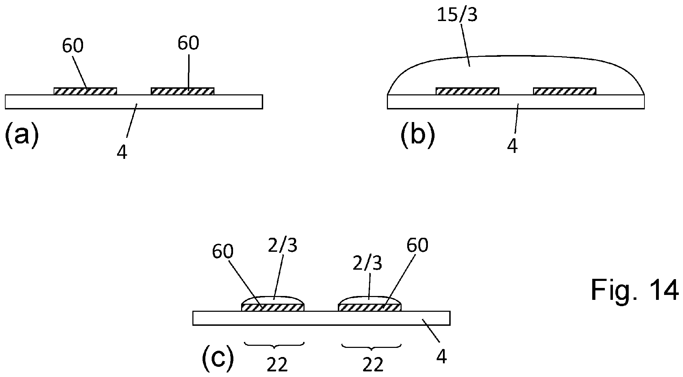

Note that local coatings with linker molecules can be used to define application zones 22 for thin films 2 to be prepared, in accordance with the invention, as shown in **Fig. 14.** In partial picture (a), a substrate 4 is shown, which carries here two local coatings 60 made from linker molecules. The substrate 4 is non-polar, for example having an upper surface of graphene. In the respective coatings 60, the linker molecules attach with their lower ends to the non-polar surface of the substrate 4 with non-polar groups, and expose polar groups at their upper ends. Now an initial large amount 15 of an aqueous embedding liquid 3 containing nanoscale biological specimen (not shown) is deposited on the substrate 4, see partial picture (b). Subsequently, excess embedding liquid 3 is removed, for example by evaporation or blotting (not shown in detail). The remaining embedding liquid 3 then forms thin films 2 on the substrate 4 on the local coatings 60, which at the same time define application zones 22 for the thin films 2, see partial picture (c). The local coatings 60 are wettable for the aqueous (and therefore polar) embedding liquid 3, whereas the remaining surface of the substrate 4 is not, so the thin films 2 are formed during reduction of the embedding liquid 3 in a self-organization process due to the wetting behaviour.

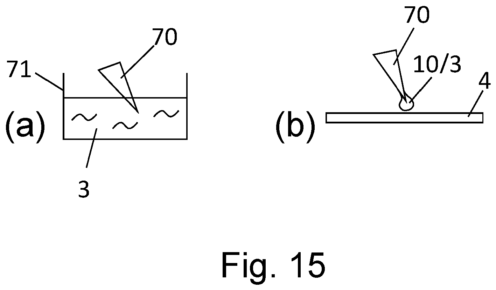

**Fig. 15** schematically illustrates the application of a thin film of embedding liquid 3 on a substrate 4, wherein the embedding liquid 3 containing nanoscale biological specimen is taken from a supply pool 71 by dipping an application tip 70 into the embedding liquid 3 contained in the supply pool 71, see partial picture (a). Then the application tip 70 is moved to a substrate 4, with a droplet 10 of embedding liquid 3 stuck to the tip 70. The tip 70 is then lowered towards the substrate 4, see partial picture (b). When the droplet 10 touches the surface of the substrate 4, the embedding liquid 3 flows down from the tip 70 and wets the substrate 4, forming a thin film on the substrate (not shown in detail); if needed the thickness of the thin film may be adjusted by blotting or evaporation, for example. Note that the application tip 70 may be chosen as an atomic force microscope (=AFM) tip.

List of reference signs

| 1 | nanoscale biological specimen |
| 1a | protein |
| 2 | thin film (thin layer) |
| 3 | (fluid or immobilized) embedding liquid |
| 3a | part of embedding liquid removed with liquid absorbing medium |
| 4 | substrate |
| 4a | thin membrane of graphene (graphene foil) |
| 5 | film thickness (in region 8b) |
| 6 | close distance (below protein) |
| 7 | covering substrate |
| 7a | second/covering thin membrane of graphene (graphene foil) |
| 8a | region of thin film at the nanoscale biological specimen |
| 8b | region of thin film adjacent to the nanoscale biological specimen |
| 9 | sample |
| 10 | droplet (of embedding liquid containing nanoscale biological specimen) |
| 11 | TEM grid |
| 12 | application tip having a microchannel |
| 13 | miniature gripper |
| 14 | liquid absorbing medium |
| 14a | filter paper |
| 15 | initial large amount of embedding liquid |
| 16 | grid bars of TEM grid |
| 16a | grid window |
| 17 | holey carbon film (carbon foil) |
| 18 | hole |
| 19 | diameter |
| 21 | maximum thickness of embedding liquid on substrate |
| 22 | application zone |
| 23 | homogenous layer thickness |
| 24 | negative stain |
| 25 | sample preparation apparatus |
| 30 | tip of sample holder |
| 31 | shaft |
| 32 | electron beam instrument |
| 33 | area outside of the vacuum |
| 34 | LN2 bath |
| 35 | copper wires |
| 36 | heating coil |
| 36a | electric wires (for heating coil) |
| 37 | DC regulating device |
| 38 | thermocouple |
| 38a | electric wires (for thermocouple) |
| 39 | measurement device |
| 40 | electron source |
| 41 | (generated) electron beam |
| 42 | electron condenser lenses |
| 43 | specimen/sample |
| 44 | (transmitted) electron beam |

| 45 | electron projector lenses |
|----|---------------------------|
| 46 | camera |
| 47 | computer |
| 50 | conductive polymers |
| 51 | conductive chain |
| 51a | unsaturated carbon bonds |
| 52 | non-polar group (here aromatic group) |
| 53 | polar group (here carboxyl group) |
| 54 | hydrogen bond |
| 55 | linker molecules |
| 60 | local coating |
| 70 | application tip (for supply pool) |
| 71 | supply pool of embedding liquid |
| 100 | step a) preparing embedding liquid |
| 200 | step b) preparing thin film |
| 300 | step c) tempering thin film |
| 400 | step d) measuring nanoscale biological specimen |
| AT | average thickness of the thin film of embedding liquid |
| AZA | application zone area |
| MD | maximum diameter of nanoscale biological specimen |
| SV | small volume |
| $\alpha$ | wetting angle |

List of references cited

| 1 | US 7,413,872=US 2004/157284 |
|----|---------|
| 2 | L. Reimer, H. Kohl, Transmission Electron Microscopy: Physics of Image Formation, Springer, 2008, page 479, equation 11.17 |
| 3 | N. de Jonge, Ultramicroscopy 187 (2019) 113-125 |
| 4 | R. F. Egerton, Micron 119 (2019) 72-87 |
| 5 | E. E. Fill, F. Krausz and M. G. Raizen, New J. Phys. 10 (2008) 93015-1-7 |
| 6 | S. Keskin and N. de Jonge, Nano Lett. 18 (2018) 7435-7440 |
| 7 | R. A. Marcus, N. Sutin, Biochim. Biophys. Acta 811 (1985) 265-322 |
| 8 | C. C. Moser et al., Nature 355 (1992) 796-802 |
| 9 | D. N. Beratan et al., Science 252 (1991) 1285-1288 |
| 10 | L. F. Kourkoutis et al., Annu. Rev. Mater. Res. 42 (2012) 33-58 |
| 11 | G. W. Gross et al., J. Glaciol. 21 (1978) 143 |
| 12 | Stillman and Grimm, Lunar and Planetary Science XXXIX (2008) 2277 |
| 13 | T. Kohno et al., IEEE Transactions on Electrical Insulation, EI-15 (1980) 27-32 |
| 14 | H. Wang et al., J. Phys. Chem. B 113 (2009) 818-824 |
| 15 | Joachim Frank, "Single-particle reconstruction of biological molecules - story in a sample", Nobel Lecture, December 8, 2017 |
| 16 | US 7,659,510= US 2009/242795 |
| 17 | US 2012/0220046 A |
| 18 | US 2010/0243482 A |
| 19 | Chih-Yu Chao, Chinese Journal of Physics Vol. 45, No. 6-I, December 2007, 557-578 |
| 20 | US 7,420,184= US 2007/252090 |
| 21 | T. Li et al, Nat. Commun. 4 (2013) 1887-1-6 |
| 22 | Xiang-Xiong Zhang et al., J. Chem. Phys. 141 (2014) 124709 |
| 23 | Wikipedia page "saline water", https://en.wikipedia.org/wiki/Saline water downloaded on 22.09.2023 |
| 24 | K. Iakoubovskii and K. Mitsuishi, J. Phys. Condens. Matter 21 (2009) 155402 |
| 25 | US 2019/131106 |
| 26 | US 2012/024086 |

**Claims**

1. A method for investigating at least one nanoscale biological specimen (1), the method comprising

   Step a) (100) preparing an embedding liquid (3) containing a plurality of the nanoscale biological specimens (1), wherein the nanoscale biological specimens (1) have a maximum diameter MD, with MD ≤ 30 nm,
   Step b) (200) preparing a thin film (2) of the embedding liquid (3) on an electrically conductive substrate (4) in an application zone (22), thereby placing the nanoscale biological specimens (1) on the substrate (4), wherein the substrate (4) is wettable for the embedding liquid (3) in the application zone (22),
   and wherein the thin film (2) of the embedding liquid (3) has an average thickness AT, with AT ≤ 30 nm,
   wherein step a) (100) and step b) (200) are done at a preparation temperature PT, with PT > 0°C;
   Step c) (300) tempering the thin film (2) on the substrate (4) to a measurement temperature MT, with -100°C≤MT≤-1°C;
   Step d) (400) measuring at least one of the nanoscale biological specimens (1) within the thin film (2) on the substrate (4) in an electron beam instrument (32) at the measurement temperature MT,
   wherein the at least one nanoscale biological specimen (1) is exposed to an electron beam (41, 44).

2. A method according to claim 1, **characterized in that** the measurement temperature MT is less than a freezing temperature of the embedding liquid (3) in bulk.

3. A method according to one of the preceding claims, **characterized in that**

$$AT \le MD.$$

4. A method according to one of the preceding claims, **characterized in that** in step d) (400), an electron beam energy of the electron beam (41, 44) is between 50 eV and 300 keV,

   preferably between 30 keV and 300 keV,
   and the electron flux of the electron beam (41, 44) is between 0.1 electrons per Å² per s and 50 electrons per Å² per s,
   preferably between 1 electrons per Å² per s and 10 electrons per Å² per s.

5. A method according to one of the preceding claims, **characterized in that** that the preparation temperature PT is chosen in a range of

$$0°C < PT \le 40°C.$$

6. A method according to one of the preceding claims, **characterized in that** during step b) (200), placing an initial large amount (15) of embedding liquid (3) on the substrate (4), with the large amount (15) being larger than needed for the thin film (2), and then reducing the amount of embedding liquid (3) on the substrate (4) until only the thin film (2) remains.

7. A method according to claim 6, **characterized in that** reducing the amount of embedding liquid (3) includes placing a liquid absorbing medium (14) in contact with the embedding liquid (3),

   in particular wherein the liquid absorbing medium (14) comprises a filter paper (14a) or a brushed metallic wire, and/or **in that** reducing the amount of embedding liquid (3) includes evaporating some of the embedding liquid (3).

8. A method according to one of the claims 1 through 5, **characterized in that** during step b) (200), for preparing the thin film (2) of embedding liquid (3) in the application zone (22) having an application zone area AZA, an initial small volume SV of embedding liquid (3) is placed on the substrate (4) in the application zone (22), with SV ≤ AT*AZA.

9. A method according to one of the preceding claims, **characterized in that** in step b) (200) an initial amount of embedding liquid (3) is placed on the substrate (4) in the application zone (22) by first dipping an application tip (70), in particular an atomic force microscopy (=AFM) tip, into a supply pool (71) of the embedding liquid (3) containing the nanoscale biological specimens (1), and then touching the application zone (22) with the application tip (70).

10. A method according to one of the preceding claims, **characterized in that** in step b) (200) an initial amount of embedding liquid (3) is placed on the substrate (4) in the application zone (22) with an application tip (12) having a microchannel through which the initial amount of the embedding liquid (3) is discharged.

11. A method according to one of the preceding claims, **characterized in that** during step b) (200), an initial volume of embedding liquid (3) placed on the substrate is between 1 fL and 2 μL.

12. A method according to one of the preceding claims, **characterized in that** experimental parameters applied during step b) (200) in order to prepare the thin film (2) with the average thickness AT have been determined in advance in calibration experiments,
in particular wherein the experimental parameters include at least one of: temperature of an atmosphere surrounding the substrate (4), pressure of an atmosphere surrounding the substrate (4), humidity of an atmosphere surrounding the substrate (4), composition of an atmosphere surrounding the substrate (4), temperature of the substrate (4), type of a liquid absorbing medium (14), contact time with a liquid absorbing medium (14), contact pressure to a liquid absorbing medium (14), evaporation time, initial large amount (15) of embedding liquid (3) placed on the substrate (4), initial small volume SV of embedding liquid (3) placed on the substrate (4) in an application zone (22), initial amount of embedding liquid (3) placed on the substrate (4), initial volume of embedding liquid (3) placed on the substrate (4), touchdown pressure of an application tip (70), discharging flow of embedding liquid (3) through a microchannel.

13. A method according to one of the preceding claims, **characterized in that** the embedding liquid (3) is chosen as water with added salt,

preferred wherein the added salt is NaCl,
particularly preferred wherein the added salt is NaCl with a concentration of 10 mM.

14. A method according of one of the preceding claims, **characterized in that** the substrate (4) is a graphene foil (4a) or carbon foil (17).

15. A method according to one of the preceding claims, **characterized in that** after step b) (200) and before step c) (300), the thin film (2) of the embedding liquid (3) is covered with a covering substrate (7), in particular wherein the covering substrate (7) is a graphene foil (7a) or a carbon foil.

16. A method according to one of the preceding claims, **characterized in that** the embedding liquid (3) contains electrically conductive polymers (50) and/or electrically conductive proteins.

17. A method according to one of the preceding claims, **characterized in that** the embedding liquid (3) contains negative stain (24),
in particular wherein the negative stain (24) is chosen as $\alpha$-D-Glucose 1-phosphate dipotassium salt hydrate, applied preferably with a concentration of 2 mM.

18. A method according to one of the preceding claims, **characterized in that** in step c) (300), the thin film (2) on the substrate (4) is first cooled down to a low temperature LT, with LT≤-196°C, and then warmed up again to the measuring temperature MT.

19. A method according to one of the preceding claims, **characterized in that** the substrate (4) is placed on a TEM grid (11), with the TEM grid (11) having a plurality of crossing grid bars (16) defining grid windows (16a) between the crossing grid bars (16), and that during step b), embedding liquid (3) is applied between grid bars (16) in at least one grid window (16a), in particular wherein embedding liquid (3) is applied deliberately between the grid bars (16) in the at least one grid window (16a).

20. A method according to one of the preceding claims, **characterized in that** the substrate (4) comprises at least one local coating (60) defining at least one application zone (22), wherein the local coating (22) provides that the substrate (4) is wettable for the embedding liquid (3) in the application zone (22).

21. A method according to one of the preceding claims, **characterized in that** the substrate (4) is at least partially coated with linker molecules (55) for linking the nanoscale biological specimens (1) to the substrate (4),

in particular wherein the nanoscale biological specimens (1) are proteins (1a) and the substrate (4) comprises a graphene foil (4a),
that the linker molecules (55) attach on one side to the substrate (4) via a non-polar chemical group or groups (52), in particular wherein the non-polar chemical group or groups (52) are based on pyrene, pyridine, porphyrin, or amine,
and that the linker molecules (55) on their other side have a polar chemical group or groups (53), in particular wherein the polar chemical group or groups (53) comprise butanoic acid-succinimidyl ester, pyrenebutyric acid (PBA) or carboxyl.

22. A method according to claim 21, **characterized in that** the linker molecules (55) contain an electrically conductive chain (51), in particular wherein the electrically conductive chain (51) is based on carbon atoms with unsaturated carbon bonds (51a) or a carotenoid or a chain of carbon atoms with oxygen atoms.

23. A method according to one of claims 21 or 22, **characterized in that** the linker molecules (55) comprise molecules for specially binding to the nanoscale biological specimens (1) to be investigated, in particular wherein the nanoscale biological specimens (1) comprise a protein (1a), an antibody, a binding peptide, a DNA sequence, a ligand for a receptor, a chelated metal, or a histidine.

24. A method according to one of the preceding claims, **characterized in that** the measurement temperature MT is chosen with -50°C≤MT≤-1°C.

25. A method for determining a flux threshold of electrons for measuring of a nanoscale biological specimen (1) with an electron beam (41, 44), comprising the following steps:

step $\alpha$) investigating a first nanoscale biological specimen (1) according to one of the preceding claims, wherein in step d) (400) the first nanoscale biological specimen (1) is exposed to a preselected electron dose at a first flux of the electrons, and a structure of the first nanoscale biological specimen (1) is detected,
Step $\beta$) investigating a further nanoscale biological specimen (1) according to one of the preceding claims, wherein in step d) (400) the further nanoscale biological specimen (1) is exposed to the preselected electron dose at a further flux of the electrons being higher than the previously applied flux of the electrons, and a further structure of the further nanoscale biological specimen (1) is detected,
Step $\gamma$) repeating the procedure of step $\beta$) until the structure of the nanoscale biological specimen (1) becomes distorted, thereby determining the flux threshold of electrons.

26. A method according to claim 25, **characterized in that** the preselected electron dose is at least 50 electrons per $(\text{Å})^2$, preferably at least 200 electrons per $(\text{Å})^2$.

27. A method for investigating at least one nanoscale biological specimen (1) according to one of the claims 1 through 24, wherein in step d) (400) the nanoscale biological specimen (1) is exposed to an electron dose and a flux of electrons, wherein the flux of electrons is below a flux threshold determined for that electron dose as preselected electron dose in a method according to claim 25 or 26.

28. Use of a sample preparation apparatus (25) in a method according to one of the claims 1 through 24, wherein the sample preparation apparatus (25) is adapted to automatically perform at least step b) (200), and preferably also step c) (300).

**Patentansprüche**

1. Verfahren zur Untersuchung mindestens einer nanoskaligen biologischen Probe (1), wobei das Verfahren umfasst:

Schritt a) (100) Herstellen einer Einbettungsflüssigkeit (3), die eine Vielzahl der nanoskaligen biologischen Proben (1) enthält, wobei die nanoskaligen biologischen Proben (1) einen maximalen Durchmesser MD haben, wobei MD ≤ 30 nm,
Schritt b) (200) Herstellen eines Dünnfilms (2) der Einbettungsflüssigkeit (3) auf einem elektrisch leitfähigen Substrat (4) in einer Applikationszone (22), wodurch die nanoskaligen biologischen Proben (1) auf dem Substrat (4) angeordnet werden,
wobei das Substrat (4) mit der Einbettungsflüssigkeit (3) in der Applikationszone (22) benetzbar ist,
und wobei der Dünnfilm (2) der Einbettungsflüssigkeit (3) eine durchschnittliche Dicke AT hat, wobei AT ≤ 30 nm,

wobei Schritt a) (100) und Schritt b) (200) bei einer Herstellungstemperatur PT durchgeführt werden, wobei PT > 0 °C;

Schritt c) (300) Tempern des Dünnfilms (2) auf dem Substrat (4) auf eine Messtemperatur MT, wobei -100 °C ≤ MT ≤ -1 °C;

Schritt d) (400) Messen mindestens einer der nanoskaligen biologischen Proben (1) innerhalb des Dünnfilms (2) auf dem Substrat (4) in einem Elektronenstrahlgerät (32) bei der Messtemperatur MT,

wobei die mindestens eine nanoskalige biologische Probe (1) einem Elektronenstrahl (41, 44) ausgesetzt wird.

2. Verfahren nach Anspruch 1, **dadurch gekennzeichnet, dass** die Messtemperatur MT unterhalb einer Gefriertemperatur der Einbettungsflüssigkeit (3) im Bulk liegt.

3. Verfahren nach einem der vorhergehenden Ansprüche, **dadurch gekennzeichnet, dass** AT ≤ MD ist.

4. Verfahren nach einem der vorhergehenden Ansprüche, **dadurch gekennzeichnet, dass** in Schritt d) (400) eine Elektronenstrahlenergie des Elektronenstrahls (41, 44) zwischen 50 eV und 300 keV liegt,

vorzugsweise zwischen 30 keV und 300 keV liegt,
und der Elektronenfluss des Elektronenstrahls (41, 44) zwischen 0,1 Elektronen pro $\text{Å}^2$ pro s und 50 Elektronen pro $\text{Å}^2$ pro s liegt,
vorzugsweise zwischen 1 Elektron pro $\text{Å}^2$ pro s und 10 Elektronen pro $\text{Å}^2$ pro s liegt.

5. Verfahren nach einem der vorhergehenden Ansprüche, **dadurch gekennzeichnet, dass** die Herstellungstemperatur PT in einem Bereich von 0 °C < PT ≤ 40 °C gewählt wird.

6. Verfahren nach einem der vorhergehenden Ansprüche, **dadurch gekennzeichnet, dass** während Schritt b) (200) eine anfängliche große Menge (15) der Einbettungsflüssigkeit (3) auf das Substrat (4) aufgebracht wird, wobei die große Menge (15) größer ist als für den Dünnfilm (2) erforderlich ist, und dann die Menge der Einbettungsflüssigkeit (3) auf dem Substrat (4) reduziert wird, bis nur noch der Dünnfilm (2) übrigbleibt.

7. Verfahren nach Anspruch 6, **dadurch gekennzeichnet, dass** die Reduzierung der Menge der Einbettungsflüssigkeit (3) das Anordnen eines flüssigkeitsabsorbierenden Mediums (14) in Kontakt mit der Einbettungsflüssigkeit (3) umfasst,

insbesondere wobei das flüssigkeitsabsorbierende Medium (14) ein Filterpapier (14a) oder einen gebürsteten Metalldraht umfasst,
und/oder dass das Reduzieren der Menge an Einbettungsflüssigkeit (3) das Verdampfen eines Teils der Einbettungsflüssigkeit (3) umfasst.

8. Verfahren nach einem der Ansprüche 1 bis 5, **dadurch gekennzeichnet, dass** während Schritt b) (200) zur Herstellung des Dünnfilms (2) aus Einbettungsflüssigkeit (3) in der Applikationszone (22) mit einem Applikationszonenbereich AZA ein anfängliches kleines Volumen SV der Einbettungsflüssigkeit (3) auf das Substrat (4) in der Applikationszone (22) aufgebracht wird, wobei SV ≤ AT*AZA.

9. Verfahren nach einem der vorhergehenden Ansprüche, **dadurch gekennzeichnet, dass** in Schritt b) (200) eine anfängliche Menge an Einbettungsflüssigkeit (3) auf das Substrat (4) in der Applikationszone (22) aufgebracht wird, indem zunächst eine Applikationsspitze (70), insbesondere eine Rasterkraftmikroskopie-Spitze (atomic force microscopy=AFM), in ein Vorratsreservoir (71) der Einbettungsflüssigkeit (3) enthaltend die nanoskaligen biologischen Proben (1) eingetaucht wird, und dann die Applikationszone (22) mit der Applikationsspitze (70) berührt wird.

10. Verfahren nach einem der vorhergehenden Ansprüche, **dadurch gekennzeichnet, dass** in Schritt b) (200) eine anfängliche Menge an Einbettungsflüssigkeit (3) auf das Substrat (4) in der Applikationszone (22) mit einer Applikationsspitze (12) aufgebracht wird, die einen Mikrokanal aufweist, durch den die anfängliche Menge der Einbettungsflüssigkeit (3) abgegeben wird.

11. Verfahren nach einem der vorhergehenden Ansprüche, **dadurch gekennzeichnet, dass** während Schritt b) (200) ein anfängliches Volumen der auf das Substrat aufgebrachten Einbettungsflüssigkeit (3) zwischen 1 fL und 2 µL liegt.

12. Verfahren nach einem der vorhergehenden Ansprüche, **dadurch gekennzeichnet, dass** während Schritt b) (200) zur Herstellung des Dünnfilms (2) mit der durchschnittlichen Dicke AT angewandte Versuchsparameter in Kalibrierungsexperimenten im Voraus bestimmt wurden,

insbesondere wobei die Versuchsparameter mindestens einen der folgenden Parameter umfassen: Temperatur einer das Substrat (4) umgebenden Atmosphäre, Druck einer das Substrat (4) umgebenden Atmosphäre, Feuchtigkeit einer das Substrat (4) umgebenden Atmosphäre, Zusammensetzung einer das Substrat (4) umgebenden Atmosphäre, Temperatur des Substrats (4), Art eines flüssigkeitsabsorbierenden Mediums (14), Kontaktzeit mit einem flüssigkeitsabsorbierenden Medium (14), Anpressdruck auf ein flüssigkeitsabsorbierendes Medium (14), Verdunstungszeit, anfängliche große Menge (15) der auf das Substrat (4) aufgebrachten Einbettungsflüssigkeit (3), anfängliches kleines Volumen SV der auf das Substrat (4) in einer Applikationszone (22) aufgebrachten Einbettungsflüssigkeit (3), anfängliche Menge der auf das Substrat (4) aufgebrachten Einbettungsflüssigkeit (3), anfängliches Volumen der auf das Substrat (4) aufgebrachten Einbettungsflüssigkeit (3), Aufsetzdruck einer Applikationsspitze (70), Abgabefluss der Einbettungsflüssigkeit (3) durch einen Mikrokanal.

13. Verfahren nach einem der vorhergehenden Ansprüche, **dadurch gekennzeichnet, dass** als Einbettungsflüssigkeit (3) Wasser mit zugesetztem Salz gewählt wird, wobei das zugesetzte Salz vorzugsweise NaCl ist, wobei das zugesetzte Salz besonders bevorzugt NaCl mit einer Konzentration von 10 mM ist.

14. Verfahren nach einem der vorhergehenden Ansprüche, **dadurch gekennzeichnet, dass** das Substrat (4) eine Graphenfolie (4a) oder eine Kohlenstofffolie (17) ist.

15. Verfahren nach einem der vorhergehenden Ansprüche, **dadurch gekennzeichnet, dass** nach Schritt b) (200) und vor Schritt c) (300) der Dünnfilm (2) der Einbettungsflüssigkeit (3) mit einem Abdecksubstrat (7) bedeckt wird, insbesondere wobei das Abdecksubstrat (7) eine Graphenfolie (7a) oder eine Kohlenstofffolie ist.

16. Verfahren nach einem der vorhergehenden Ansprüche, **dadurch gekennzeichnet, dass** die Einbettungsflüssigkeit (3) elektrisch leitfähige Polymere (50) und/oder elektrisch leitfähige Proteine enthält.

17. Verfahren nach einem der vorhergehenden Ansprüche, **dadurch gekennzeichnet, dass** die Einbettungsflüssigkeit (3) einen Negativfärbstoff (24) enthält, insbesondere wobei als Negativfärbstoff (24) $\alpha$-D-Glucose-1-Phosphat Dikaliumsalzhydrat ausgewählt wird, das vorzugsweise in einer Konzentration von 2 mM aufgebracht wird.

18. Verfahren nach einem der vorhergehenden Ansprüche, **dadurch gekennzeichnet, dass** in Schritt c) (300) der Dünnfilm (2) auf dem Substrat (4) zunächst auf eine niedrige Temperatur LT, mit LT $\leq$ -196 °C, abgekühlt und dann wieder auf die Messtemperatur MT erwärmt wird.

19. Verfahren nach einem der vorhergehenden Ansprüche, **dadurch gekennzeichnet, dass** das Substrat (4) auf einem TEM-Gitter (11) angeordnet wird, wobei das TEM-Gitter (11) eine Vielzahl von sich kreuzenden Gitterstäben (16) aufweist, die zwischen den sich kreuzenden Gitterstäben (16) Gitterfenster (16a) definieren, und dass während Schritt b) Einbettungsflüssigkeit (3) zwischen Gitterstäben (16) in mindestens einem Gitterfenster (16a) aufgebracht wird,

insbesondere wobei Einbettungsflüssigkeit (3) gezielt zwischen den Gitterstäben (16) in dem mindestens einen Gitterfenster (16a) aufgebracht wird.

20. Verfahren nach einem der vorhergehenden Ansprüche, **dadurch gekennzeichnet, dass** das Substrat (4) mindestens eine lokale Beschichtung (60) umfasst, die mindestens eine Applikationszone (22) definiert, wobei die lokale Beschichtung (22) dafür sorgt, dass das Substrat (4) mit der Einbettungsflüssigkeit (3) in der Applikationszone (22) benetzbar ist.

21. Verfahren nach einem der vorhergehenden Ansprüche, **dadurch gekennzeichnet, dass** das Substrat (4) zumindest teilweise mit Linkermolekülen (55) beschichtet ist, um die nanoskaligen biologischen Proben (1) mit dem Substrat (4) zu verbinden, insbesondere wobei die nanoskaligen biologischen Proben (1) Proteine (1a) sind und das Substrat (4) eine Graphenfolie (4a) umfasst,

dass die Linkermoleküle (55) auf einer Seite über eine unpolare chemische Gruppe oder Gruppen (52) an das Substrat (4) gebunden sind, insbesondere wobei die unpolare chemische Gruppe oder Gruppen (52) auf Pyren, Pyridin, Porphyrin oder Amin basieren, und dass die Linkermoleküle (55) auf ihrer anderen Seite eine polare chemische Gruppe oder Gruppen (53) aufweisen, insbesondere wobei die polare chemische Gruppe oder Gruppen (53) Butansäure-Succinimidylester, Pyrenbutansäure (PBA) oder Carboxyl umfassen.

22. Verfahren nach Anspruch 21, **dadurch gekennzeichnet, dass** die Linkermoleküle (55) eine elektrisch leitfähige Kette (51) enthalten, insbesondere wobei die elektrisch leitfähige Kette (51) auf Kohlenstoffatomen mit ungesättigten Kohlenstoffbindungen (51a) oder einem Carotinoid oder einer Kette von Kohlenstoffatomen mit Sauerstoffatomen basiert.

23. Verfahren nach einem der Ansprüche 21 oder 22, **dadurch gekennzeichnet, dass** die Linkermoleküle (55) Moleküle zur speziellen Bindung an die zu untersuchenden nanoskaligen biologischen Proben (1) enthalten, insbesondere wobei die nanoskaligen biologischen Proben (1) ein Protein (1a), einen Antikörper, ein bindendes Peptid, eine DNA-Sequenz, einen Liganden für einen Rezeptor, ein chelatisiertes Metall oder ein Histidin umfassen.

24. Verfahren nach einem der vorhergehenden Ansprüche, **dadurch gekennzeichnet, dass** die Messtemperatur MT mit -50 °C ≤ MT ≤ -1 °C gewählt wird.

25. Verfahren zum Bestimmen eines Elektronenfluss-Schwellenwerts zum Messen einer nanoskaligen biologischen Probe (1) mit einem Elektronenstrahl (41, 44), umfassend die folgenden Schritte:

Schritt $\alpha$) Untersuchen einer ersten nanoskaligen biologischen Probe (1) nach einem der vorhergehenden Ansprüche, wobei in Schritt d) (400) die erste nanoskalige biologische Probe (1) einer vorgewählten Elektronendosis bei einem ersten Elektronenfluss ausgesetzt wird, und eine Struktur der ersten nanoskaligen biologischen Probe (1) detektiert wird,
Schritt $\beta$) Untersuchen einer weiteren nanoskaligen biologischen Probe (1) nach einem der vorhergehenden Ansprüche, wobei in Schritt d) (400) die weitere nanoskalige biologische Probe (1) der vorgewählten Elektronendosis bei einem weiteren Elektronenfluss ausgesetzt wird, der höher ist als der zuvor angewendete Elektronenfluss, und eine weitere Struktur der weiteren nanoskaligen biologischen Probe (1) detektiert wird,
Schritt $\gamma$) Wiederholen des Verfahrens von Schritt $\beta$), bis die Struktur der nanoskaligen biologischen Probe (1) verzerrt wird, wodurch der Elektronenfluss-Schwellenwert bestimmt wird.

26. Verfahren nach Anspruch 25, **dadurch gekennzeichnet, dass** die vorgewählte Elektronendosis mindestens 50 Elektronen pro $(\text{Å})^2$, vorzugsweise mindestens 200 Elektronen pro $(\text{Å})^2$ beträgt.

27. Verfahren zur Untersuchung mindestens einer nanoskaligen biologischen Probe (1) nach einem der Ansprüche 1 bis 24,
wobei in Schritt d) (400) die nanoskalige biologische Probe (1) einer Elektronendosis und einem Elektronenfluss ausgesetzt wird, wobei der Elektronenfluss unter einem Fluss-Schwellenwert liegt, der für diese Elektronendosis als vorgewählte Elektronendosis in einem Verfahren nach Anspruch 25 oder 26 bestimmt wurde.

28. Verwendung einer Probenpräparationsapparatur (25) in einem Verfahren nach einem der Ansprüche 1 bis 24, wobei die Probenpräparationsapparatur (25) so ausgelegt ist, dass sie zumindest Schritt b) (200), und vorzugsweise auch Schritt c) (300), automatisch ausführt.

**Revendications**

1. Procédé d'étude d'au moins un spécimen biologique nanométrique (1), le procédé comprenant

Etape a) (100) préparer un liquide d'inclusion (3) contenant une pluralité des spécimens biologiques nanométriques (1), où les spécimens biologiques nanométriques (1) ont un diamètre maximal MD, avec MD ≤ 30 nm,
Etape b) (200) préparer un film mince (2) du liquide d'inclusion (3) sur un substrat électriquement conducteur (4) dans une zone d'application (22), en plaçant ainsi les spécimens biologiques nanométriques (1) sur le substrat (4), où le substrat (4) est mouillable pour le liquide d'inclusion (3) dans la zone d'application (22),
et où le film mince (2) du liquide d'inclusion (3) présente une épaisseur moyenne AT, avec AT ≤ 30 nm,
où l'étape a) (100) et l'étape b) (200) sont réalisées à une température de préparation PT, avec PT > 0 °C ;
Etape c) (300) durcir le film mince (2) sur le substrat (4) à une température de mesure MT, avec -100 °C ≤ MT ≤ -1 °C ;
Etape d) (400) mesurer au moins un des spécimens biologiques nanométriques (1) dans le film mince (2) sur le substrat (4) dans un instrument à faisceau d'électrons (32) à la température de mesure MT,

où le au moins un spécimen biologique nanométrique (1) est exposé à un faisceau d'électrons (41, 44).

2. Procédé selon la revendication 1, **caractérisé en ce que** la température de mesure MT est inférieure à une température de congélation du liquide d'inclusion (3) en masse.

3. Procédé selon l'une des revendications précédentes, **caractérisé en ce que**

$$AT \leq MD.$$

4. Procédé selon l'une des revendications précédentes, **caractérisé en ce que** à l'étape d) (400), une énergie de faisceau d'électrons du faisceau d'électrons (41, 44) est comprise entre 50 eV et 300 keV,

de préférence entre 30 keV et 300 keV,
et le flux d'électrons du faisceau d'électrons (41, 44) est compris entre 0,1 électron par Å$^2$ par seconde et 50 électrons par Å$^2$ par seconde,
de préférence entre 1 électron par Å$^2$ par seconde et 10 électrons par Å$^2$ par seconde.

5. Procédé selon l'une des revendications précédentes, **caractérisé en ce que** la température de préparation PT est choisie dans une plage de 0 °C < PT ≤ 40 °C.

6. Procédé selon l'une des revendications précédentes, **caractérisé en ce que** durant l'étape b) (200), une importante quantité initiale (15) de liquide d'inclusion (3) est placée sur le substrat (4), l'importante quantité (15) étant supérieure à ce qui est nécessaire pour le film mince (2), puis réduire la quantité de liquide d'inclusion (3) sur le substrat (4) jusqu'à ce qu'il ne reste que le film mince (2).

7. Procédé selon la revendication 6, **caractérisé en ce que** réduire la quantité de liquide d'inclusion (3) inclut le fait de placer un milieu absorbant les liquides (14) en contact avec le liquide d'inclusion (3),

en particulier où le milieu absorbant les liquides (14) comprend un papier filtre (14a) ou un fil métallique brossé, et/ou **en ce que** réduire la quantité de liquide d'inclusion (3) inclut le fait d'évaporer une certaine quantité du liquide d'inclusion (3).

8. Procédé selon l'une des revendications 1 à 5, **caractérisé en ce que** durant l'étape b) (200), pour préparer le film mince (2) de liquide d'inclusion (3) dans la zone d'application (22) présentant une aire de zone d'application AZA, un faible volume initial SV de liquide d'inclusion (3) est placé sur le substrat (4) dans la zone d'application (22), avec SV ≤ AT * AZA.

9. Procédé selon l'une des revendications précédentes, **caractérisé en ce que** lors de l'étape b) (200), une quantité initiale de liquide d'inclusion (3) est placée sur le substrat (4) dans la zone d'application (22) en plongeant d'abord une pointe d'application (70), en particulier une pointe de microscopie à force atomique (MFA), dans un réservoir d'alimentation (71) du liquide d'inclusion (3) contenant les spécimens biologiques nanométriques (1), puis en touchant la zone d'application (22) avec la pointe d'application (70).

10. Procédé selon l'une des revendications précédentes, **caractérisé en ce que** lors de l'étape b) (200), une quantité initiale de liquide d'inclusion (3) est placée sur le substrat (4) dans la zone d'application (22) avec une pointe d'application (70) comportant un microcanal à travers lequel la quantité initiale du liquide d'inclusion (3) est évacuée.

11. Procédé selon l'une des revendications précédentes, **caractérisé en ce que** durant l'étape b) (200), un volume initial de liquide d'inclusion (3) placé sur le substrat est compris entre 1 fL et 2 µL.

12. Procédé selon l'une des revendications précédentes, **caractérisé en ce que** des paramètres expérimentaux appliqués durant l'étape b) (200) afin de préparer le film mince (2) avec l'épaisseur moyenne AT ont été déterminés au préalable lors d'expériences d'étalonnage,
en particulier où les paramètres expérimentaux incluent au moins l'un des points suivants : température d'une atmosphère entourant le substrat (4), pression d'une atmosphère entourant le substrat (4), humidité d'une atmosphère entourant le substrat (4), composition d'une atmosphère entourant le substrat (4), température du substrat (4), type de milieu absorbant les liquides (14), durée de contact avec un milieu absorbant les liquides (14), pression de contact sur un milieu absorbant les liquides (14), durée d'évaporation, importante quantité initiale (15) de liquide d'inclusion (3) placée sur le substrat (4), faible volume initial (SV) de liquide d'inclusion (3) placé sur le substrat (4) dans une zone d'application (22), quantité initiale de liquide d'inclusion (3) placée sur le substrat (4), volume initial de liquide d'inclusion (3) placé sur le substrat (4), pression d'appui d'une pointe d'application (70), débit d'évacuation de liquide d'inclusion (3) à travers un microcanal.

13. Procédé selon l'une des revendications précédentes, **caractérisé en ce que** le liquide d'inclusion (3) choisi est de l'eau avec un sel ajouté,

    de préférence où le sel ajouté est NaCl,
    de manière particulièrement préférée où le sel ajouté est NaCl à une concentration de 10 mM.

14. Procédé selon l'une des revendications précédentes, **caractérisé en ce que** le substrat (4) est une feuille de graphène (4a) ou une feuille de carbone (17).

15. Procédé selon l'une des revendications précédentes, **caractérisé en ce que** après l'étape b) (200) et avant l'étape c) (300), le film mince (2) du liquide d'inclusion (3) est recouvert d'un substrat de recouvrement (7), en particulier où le substrat de recouvrement (7) est une feuille de graphène (7a) ou une feuille de carbone.

16. Procédé selon l'une des revendications précédentes, **caractérisé en ce que** le liquide d'inclusion (3) contient des polymères électriquement conducteurs (50) et/ou des protéines électriquement conductrices.

17. Procédé selon l'une des revendications précédentes, **caractérisé en ce que** le liquide d'inclusion (3) contient un colorant négatif (24),
    en particulier où le colorant négatif (24) choisi est de l'hydrate de sel dipotassique de $\alpha$-D-glucose-1-phosphate, appliqué de préférence à une concentration de 2 mM.

18. Procédé selon l'une des revendications précédentes, **caractérisé en ce que** lors de l'étape c) (300), le film mince (2) sur le substrat (4) est d'abord refroidi à une basse température LT, avec LT $\leq$ -196 °C, puis réchauffé pour le porter à nouveau à la température de mesure MT.

19. Procédé selon l'une des revendications précédentes, **caractérisé en ce que** le substrat (4) est placé sur une grille MET (11), la grille MET (11) comportant une pluralité de barres de grille se croisant (16) définissant des fenêtres de grille (16a) entre les barres de grille se croisant (16), et **en ce que** durant l'étape b), du liquide d'inclusion (3) est appliqué entre les barres de grille (16) dans au moins une fenêtre de grille (16a), en particulier où du liquide d'inclusion (3) est appliqué délibérément entre les barres de grille (16) dans la au moins une fenêtre de grille (16a).

20. Procédé selon l'une des revendications précédentes, **caractérisé en ce que** le substrat (4) comprend au moins un revêtement local (60) définissant au moins une zone d'application (22), où le revêtement local (60) permet que le substrat (4) soit mouillable pour le liquide d'inclusion (3) dans la zone d'application (22).

21. Procédé selon l'une des revendications précédentes, **caractérisé en ce que** le substrat (4) est au moins partiellement revêtu de molécules de liant (55) afin de lier les spécimens biologiques nanométriques (1) au substrat (4), en particulier où les spécimens biologiques nanométriques (1) sont des protéines (1a) et le substrat (4) comprend une feuille de graphène (4a),

    **en ce que** les molécules de liant (55) se fixent d'un premier côté au substrat (4) via un ou plusieurs groupements chimiques non polaires (52), en particulier où les un ou plusieurs groupements chimiques non polaires (52) se composent de pyrène, de pyridine, de porphyrine, ou d'amine,
    et **en ce que** les molécules de liant (55) sur leur autre côté ont un ou plusieurs groupements chimiques polaires (53), en particulier où les un ou plusieurs groupements chimiques polaires (53) comprennent un ester succinimidylique d'acide butanoïque, un acide pyrènebutyrique (PBA) ou un carboxyle.

22. Procédé selon la revendication 21, **caractérisé en ce que** les molécules de liant (55) contiennent une chaîne électriquement conductrice (51), en particulier où la chaîne électriquement conductrice (51) se compose d'atomes de carbone avec des liaisons carbone insaturées (51a) ou d'un caroténoïde ou d'une chaîne d'atomes de carbone avec des atomes d'oxygène.

**23.** Procédé selon l'une des revendications 21 ou 22, **caractérisé en ce que** les molécules de liant (55) comprennent des molécules destinées à se lier sélectivement aux spécimens biologiques nanométriques (1) à étudier, en particulier où les spécimens biologiques nanométriques (1) comprennent une protéine (1a), un anticorps, un peptide de liaison, une séquence d'ADN, un ligand pour un récepteur, un métal chélaté, ou une histidine.

**24.** Procédé selon l'une des revendications précédentes, **caractérisé en ce que** la température de mesure MT est choisie comme suit : -50 °C $\leq$ MT $\leq$ -1 °C.

**25.** Procédé de détermination d'un flux seuil d'électrons pour mesurer un spécimen biologique nanométrique (1) avec un faisceau d'électrons (41, 44), comprenant les étapes suivantes :

Etape $\alpha$) étudier un premier spécimen biologique nanométrique (1) selon l'une des revendications précédentes, où lors de l'étape d) (400) le premier spécimen biologique nanométrique (1) est exposé à une dose d'électrons présélectionnée à un premier flux des électrons, et une structure du premier spécimen biologique nanométrique (1) est détectée,
Etape $\beta$) étudier un autre spécimen biologique nanométrique (1) selon l'une des revendications précédentes, où lors de l'étape d) (400) l'autre spécimen biologique nanométrique (1) est exposé à la dose d'électrons présélectionnée à un autre flux des électrons qui est supérieur au flux des électrons précédemment appliqué, et une autre structure de l'autre spécimen biologique nanométrique (1) est détectée,
Etape $\gamma$) répéter la procédure de l'étape $\beta$) jusqu'à ce que la structure du spécimen biologique nanométrique (1) se déforme, en déterminant ainsi le flux seuil d'électrons.

**26.** Procédé selon la revendication 25, **caractérisé en ce que** la dose d'électrons présélectionnée est d'au moins 50 électrons par $(\text{Å})^2$, de préférence d'au moins 200 électrons par $(\text{Å})^2$.

**27.** Procédé d'étude d'au moins un spécimen biologique nanométrique (1) selon l'une des revendications 1 à 24, où lors de l'étape d) (400) le spécimen biologique nanométrique (1) est exposé à une dose d'électrons et un flux d'électrons, où le flux d'électrons est inférieur à un flux seuil déterminé pour cette dose d'électrons en tant que dose d'électrons présélectionnée dans un procédé selon la revendication 25 ou 26.

**28.** Utilisation d'un appareil de préparation d'échantillon (25) dans un procédé selon l'une des revendications 1 à 24, où l'appareil de préparation d'échantillon (25) est conçu pour réaliser automatiquement au moins l'étape b) (200), et de préférence également l'étape c) (300).

```
┌─────────────────────────┐
│  Preparing embedding liquid │
│            100              │
└─────────────────────────┘
             │
             ▼
┌─────────────────────────┐
│    Preparing thin film      │
│            200              │
└─────────────────────────┘
             │
             ▼
┌─────────────────────────┐
│    Tempering thin film      │
│            300              │
└─────────────────────────┘
             │
             ▼
┌─────────────────────────┐
│   Measuring nanoscale       │
│   biological specimen       │
│            400              │
└─────────────────────────┘
```

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

71

70

(a)

3

70

10/3

4

(b)

# Fig. 15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7413872 B
- US 7659510 B
- US 20120220046 A
- US 20100243482 A
- US 7420184 B
- US 20230282470 A1
- WO 2015134575 A1
- US 2004157284 A
- US 2019131106 A
- US 2012024086 A
- US 2007252090 A
- US 2009242795 A

### Non-patent literature cited in the description

- **L. REIMER** ; **H. KOHL**. Transmission Electron Microscopy: Physics of Image Formation. Springer, 2008, 479
- **N. DE JONGE**. *Ultramicroscopy*, 2019, vol. 187, 113-125
- **R. F. EGERTON**. *Micron*, 2019, vol. 119, 72-87
- **E. E. FILL** ; **F. KRAUSZ** ; **M. G. RAIZEN**. *New J. Phys.*, 2008, vol. 10, 93015-1, 7
- **S. KESKIN** ; **N. DE JONGE**. *Nano Lett.*, 2018, vol. 18, 7435-7440
- **R. A. MARCUS** ; **N. SUTIN**. *Biochim. Biophys. Acta*, 1985, vol. 811, 265-322
- **C. C. MOSER et al.** *Nature*, 1992, vol. 355, 796-802
- **D. N. BERATAN et al.** *Science*, 1991, vol. 252, 1285-1288
- **L. F. KOURKOUTIS et al.** *Annu. Rev. Mater. Res.*, 2012, vol. 42, 33-58
- **G. W. GROSS et al.** *J. Glaciol*, 1978, vol. 21, 143
- **STILLMAN** ; **GRIMM**. *Lunar and Planetary Science*, 2008, vol. XXXIX, 2277
- **T. KOHNO et al.** *IEEE Transactions on Electrical Insulation*, 1980, vol. EI-15, 27-32
- **H. WANG et al.** *J. Phys. Chem. B*, 2009, vol. 113, 818-824
- **JOACHIM FRANK**. Single-particle reconstruction of biological molecules - story in a sample. *Nobel Lecture*, 08 December 2017
- **CHIH-YU CHAO**. *Chinese Journal of Physics*, December 2007, vol. 45 (6-I), 557-578
- **MARTHA ILETT et al.** Cryo-analytical STEM of frozen, aqueous dispersions of nanoparticles. *Micron*, 2019, vol. 120, 35-42
- **NICOLE HONDOW et al.** Quantitative characterization of nanoparticle agglomeration within biological media. *Journal of Nanoparticle Research*, 2012, vol. 14 (7), 1-15
- **T. LI et al.** *Nat. Commun*, 2013, vol. 4, 1887-1, 6
- **XIANG-XIONG ZHANG et al.** *J. Chem. Phys.*, 2014, vol. 141, 124709
- **C.C. MOSER et al.** *Nature*, 1992, vol. 355, 796
- **G. W. GROSS et al.** *J. Glaciol.*, 1978, vol. 21, 143
- **T. KOHNO et al.** *IEEE Transactions on Electrical Insulation*, 1980, vol. EI-15, 27
- **K. IAKOUBOVSKII** ; **K. MITSUISHI**. *J. Phys. Condens. Matter*, 2009, vol. 21, 155402
- **G. W. GROSS et al.** *Glaciol.*, 1978, vol. 21, 143
- **T. LI et al.** *Nat. Commun.*, 2013, vol. 4, 1887-1, 6
- **XIANG-XIONG ZHANG et al.** *J. Chem. Phys*, 2014, vol. 141, 124709
- saline water. *Wikipedia*, 22 September 2023, https://en.wikipedia.org/wiki/Saline water